(19) Europäisches Patentamt
European Patent Office
Office européen des brevets

(11) **EP 3 512 085 A1**

(12) **EUROPÄISCHE PATENTANMELDUNG**

(43) Veröffentlichungstag:
**17.07.2019 Patentblatt 2019/29**

(51) Int Cl.:
**H02M 3/156** *(2006.01)*          **H02M 3/335** *(2006.01)*
**H02M 1/44** *(2007.01)*          *H02M 1/00* *(2006.01)*

(21) Anmeldenummer: **18151431.6**

(22) Anmeldetag: **12.01.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD TN**

(71) Anmelder: **Fraunhofer-Gesellschaft zur Förderung der angewandten Forschung e.V. 80686 München (DE)**

(72) Erfinder: **Matlok, Stefan 91054 Erlangen (DE)**

(74) Vertreter: **König, Andreas Rudolf et al Schoppe, Zimmermann, Stöckeler Zinkler, Schenk & Partner mbB Patentanwälte Radlkoferstraße 2 81373 München (DE)**

(54) **GLEICHSPANNUNGSWANDLER MIT PARASITÄREN RESONANZKREISEN UND ULTRA-STEILEN SCHALTFLANKEN**

(57) Eine Vorrichtung umfasst einen Gleichspannungswandler mit einem Halbleiterschalter und mit einer Stromquelle, wobei der Gleichspannungswandler einen Kommutierungsschwingkreis aufweist, der zumindest teilweise von parasitären Eigenschaften des Gleichspannungswandlers bestimmt ist. Die Vorrichtung umfasst eine Ansteuereinrichtung, die konfiguriert ist, um den Halbleiterschalter durch Ausführen eines Schaltvorgangs zu schalten. Die Ansteuereinrichtung ist konfiguriert, um den Schaltvorgang mit einer Schaltdauer auszuführen, die kleiner ist als eine Periodendauer einer Resonanzfrequenz des Kommutierungsschwingkreises. Die Ansteuereinrichtung ist ferner ausgebildet, um einen Zeitpunkt des Schaltvorgangs so zu wählen, dass ein durch die Stromquelle bereitgestellter Strom ein Überschwingen an dem Halbleiterschalter von höchstens 30% bezogen auf einen Ruhezustand des Halbleiterschalters erzeugt.

Fig. 1

EP 3 512 085 A1

**Beschreibung**

Die vorliegende Erfindung bezieht sich auf eine Vorrichtung mit einem Gleichspannungswandler, insbesondere einen Gleichspannungswandler mit einem Halbleiterschalter, der so angesteuert wird, dass er trotz hoher Schaltgeschwindigkeit geringe Spannungsüberschwingungen während des Schaltens aufweist. Die vorliegende Erfindung bezieht sich ferner auf Zero Overvoltage Switching (ZOS), das bedeutet, einen Spannungswandler mit geringen Spannungsüberhöhungen.

In der Leistungselektronik gibt es unzählige Topologien und Schaltungen, welche einen Strompfad mit Hilfe eines Transistors ein- und abschalten.

Der zu schaltende Strompfad besteht aus einem elektrischen Leiter und einer Leiterschleife, welche aufgrund von Naturgesetzen auch immer eine parasitäre Induktivität bildet. Diese Induktivität, typischerweise im Bereich von 1 bis 100 nH, verhindert, dass der Schaltvorgang beliebig schnell ablaufen kann. Mit zunehmend schnelleren Schaltvorgängen im Bereich von 1 bis 1000 ns (je nach Leistungsklasse) entstehen insbesondere beim Abschalten hohe Abschaltüberspannungen am Schaltelement, das bedeutet, am Transistor.

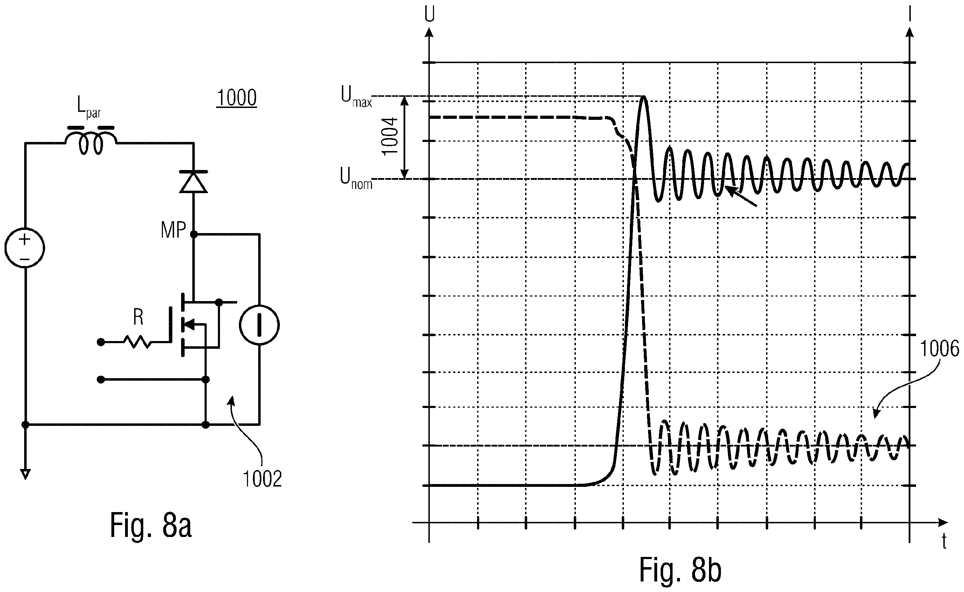

Fig. 8a und Fig. 8b zeigen ein schematisches Blockschaltbild eines Gleichspannungswandlers 1000 gemäß dem Stand der Technik sowie einen schematischen Graphen mit einem Verlauf einer Spannung U und einem Strom I durch einen MOSFET 1002 (MOSFET = metal oxide semiconductor field-effect transistor; Metalloxid-Halbleiter Feldeffekttransistor), die an einer gemeinsamen Zeitachse t angetragen sind. Beispielsweise weist der Gleichspannungswandler 1000 einen Gatewiderstand R von beispielsweise 10 Ohm auf, was zu einer deutlich reduzierten Schaltgeschwindigkeit verglichen mit einer Abwesenheit des Gate-Widerstands führt. Dennoch können beim Abschalten des MOSFET 1002 Überspannungen oder ein Überschwingen 1004 entstehen, die durch ein Überschreiten einer nominellen Spannung $U_{nom}$ bis hin zu einem maximalen Spannungslevel $U_{max}$ bezeichnet werden können, das bedeutet, ein Überschwingen 1004 kann definiert werden als $U_{max} - U_{nom}$ bzw. als Betrag hiervon. Beträgt die Spannung einer Spannungsquelle oder die zu erreichende Spannung $U_{nom}$ beispielsweise 800 V, so kann $U_{max}$ bis hin zu 1000 V erreichen, so dass die Überspannung 1004 einen Wert von 200 V betragen kann. Hierbei handelt es sich lediglich um exemplarische Werte. Die in Fig. 8b gezeigten anschließenden Oszillationen 1006 des Stromes und der Spannung können Probleme mit der elektromagnetischen Verträglichkeit (EMV) hervorrufen.

In anderen Worten zeigen die Fig. 8a und die Fig. 8b einen klassischen Doppelpulsversuchsaufbau mit realen Bauelementen, das bedeutet, keine idealen Schalter oder Dioden.

Dieses Problem der Abschalt-Überspannung durch die parasitäre Induktivität wird in der Fachwelt seit Jahrzehnten problematisiert. Bekannte Abhilfemaßnahmen sind beispielsweise das Abbremsen des Schaltvorgangs durch größere Gatevorwiderstände. Das führt jedoch zu hohen und unerwünschten Schaltverlusten.

Andere Konzepte nutzen eine veränderte Topologie, beispielsweise resonante Schaltungen, mit entsprechenden anderen Vor- und Nachteilen.

Andere Konzepte zielen auf die Minimierung der Kommutierungsinduktivität durch ein Hinzufügen von Pulskondensatoren oder sogenannten Snubbern.

Allerdings stellen sich auch neue Herausforderungen, etwa durch SiC-Schalter und/oder GaN-Schalter und/oder moderne und sehr schnelle Si-Schalter, wie beispielsweise IGBT 5 und/oder Si-MOSFETs. Diese können, sofern es zugelassen wird, extrem schnell schalten, so dass Schaltdauern im Bereich von 10 ns und darunter mit dem Schalter realisierbar sind. Seit Jahren versucht die Fachwelt daher, niederinduktive Geometrien der Kommutierungszelle aufzubauen. Dies umfasst ein Verringern der Leiterabstände, ein Einsetzen von Folien anstelle von Drähten, ein Ausbilden von flachen Anschlusspads sowie eine Verwendung von Leiterplatten und SMD-Technik (SMD = surface mounted device, oberflächenmontiertes Bauteil) anstelle von diskreten Transistorgehäusen und Modulen.

Wünschenswert wären demnach Konzepte zum Steuern von Gleichspannungswandlern, die geringe Schaltungsverluste und geringe Überspannungen ermöglichen.

Eine Aufgabe der vorliegenden Erfindung besteht deshalb darin, Konzepte zum Ansteuern eines und Auslegen von Schaltungen für einen Gleichspannungswandlers zu schaffen, die geringe Verluste und geringe Überspannungen in dem Gleichspannungswandler ermöglichen.

Diese Aufgabe wird durch den Gegenstand des unabhängigen Patentanspruchs 1 gelöst.

Ein Kerngedanke der vorliegenden Erfindung besteht darin, erkannt zu haben, dass die parasitären Elemente/Kapazitäten und Induktivitäten parasitäre Schwingkreise bilden, welche sich durch besonders kurze Schaltzeiten und einer geeigneten Wahl des zu schaltenden Stroms in besonders vorteilhafter weiße für den Schaltvorgang nutzen lassen. Vorteilhaft ist hierbei die minimale/kurze Schaltzeit, welche geringe/keine Schaltverluste ermöglicht bei gleichzeitig geringer/keiner Abschaltüberspannung und geringer/keiner parasitärer Oszillation trotz vorhandener parasitärer Kommutierungskreisinduktivität.

Gemäß einem Ausführungsbeispiel umfasst eine Vorrichtung einen Gleichspannungswandler mit einem Halbleiterschalter und einer Stromquelle. Der Gleichspannungswandler weist einen Kommutierungsschwingkreis auf, der zumindest teilweise von parasitären Eigenschaften des Gleichspannungswandlers sowie von den Schaltzuständen der aktiven Bauelemente bestimmt ist. Die Vorrichtung umfasst eine Ansteuereinrichtung, die konfiguriert ist, um den Halbleiterschalter durch Ausführen eines Schaltvorgangs zu schalten. Die Ansteuereinrichtung ist konfiguriert, um den Schaltvorgang mit einer Schaltdauer auszuführen, die kleiner ist, als eine Periodendauer einer Resonanzfrequenz der Kommutierungsschwingkreise. Die Ansteuereinrichtung ist ausgebildet, um einen Zeitpunkt des Schaltvorgangs so zu wählen, dass ein durch die Stromquelle bereitgestellter fließender Strom ein Überschwingen an dem Halbleiterschalter von höchstens 30% bezogen auf einen Ruhezustand des Halbleiters erzeugt.

Gemäß einem Ausführungsbeispiel weist der Gleichspannungswandler ein Freilaufelement auf, die mit dem Halbleiterschalter Teil eines Kommutierungskreises ist. Dieses Freilaufelement kann beispielsweise eine Diode oder ein Transistor sein. Ein parallel zu dem Freilaufelement wirkender erster elektrischer Kapazitätswert und ein parallel zu dem Halbleiterschalter wirkender zweiter elektrischer Kapazitätswert sind innerhalb eines Toleranzbereichs von 30% gleich, wobei der erste Kapazitätswert und der zweite Kapazitätswert in dem Kommutierungsschwingkreis wirken. Die Symmetrie der Kapazitäten ermöglicht einen besonders vorteilhaften Schaltvorgang.

Gemäß einem Ausführungsbeispiel ist der erste elektrische Kapazitätswert oder der zweite elektrische Kapazitätswert durch eine Kombination eines parasitären elektrischen Kapazitätswerts und eines kapazitiven Bauelements gebildet. Das bedeutet, dass zusätzlich zu parasitären Kapazitätswerten Bauelemente mit kapazitiven Eigenschaften angeordnet werden können, um den gewünschten Kapazitätswert zu erhalten. Dies ermöglicht eine Anpassung einer beliebigen Gleichspannungswandlerschaltung an die vorgesehene Betriebsart.

Gemäß einem Ausführungsbeispiel umfasst der Kommutierungsschwingkreis zumindest einen parallel zu den aktiven Bauelementen wirkenden elektrischen Kapazitätswert und einen in Serie geschalteten elektrischen Induktivitätswert. Bei dem elektrischen Induktivitätswert kann es sich um parasitäre Streuinduktivitäten oder hinzugefügte Induktivitäten handeln, die gemeinsam mit den Kapazitäten einen Schwingkreis bilden können.

Gemäß einem Ausführungsbeispiel ist die Ansteuereinrichtung ausgebildet, um das Überschwingen an dem Halbleiterschalter von höchstens 30% bezogen auf den Ruhezustand des Halbleiterschalters zu erzeugen, den Zeitpunkt des Schaltvorgangs so zu wählen, dass der durch die Stromquelle bereitgestellte Strom innerhalb eines Toleranzbereichs von 30% folgender Bedingung genügt:

$$I_{PH} = \frac{2U_{ZK}\sqrt{2\frac{C_{par}}{L_{par}}}}{\pi}$$

$I_{PH}$ umfasst den Strom der Stromquelle zum Schaltzeitpunkt, $U_{ZK}$ umfasst eine elektrische Spannung

des Gleichspannungswandlers, $C_{par}$ umfasst einen parasitären elektrischen Kapazitätswert des Gleichspannungswandlers und $L_{par}$ umfasst einen parasitären Induktivitätswert des Gleichspannungswandlers. Vorteilhaft ist, dass durch die Einhaltung der obigen Bedingung mit zunehmender Exaktheit ein zunehmend geringeres Maß an Überschwingungen erhalten werden kann.

Gemäß einem Ausführungsbeispiel ist die Ansteuereinrichtung ausgebildet, um den Schaltvorgang mit einer Schaltdauer auszuführen, die kleiner ist, als die Hälfte einer Periodendauer einer Resonanzfrequenz des Kommutierungsschwingkreises. Dies ermöglicht eine stufenförmige oder eine Anregung gemäß einer sogenannten Stufenfunktion/Heaviside Funktion und somit ein geringes Maß an Überschwingungen.

Gemäß einem Ausführungsbeispiel ist die Ansteuereinrichtung ausgebildet, um den Schaltvorgang mit einer Schaltdauer auszuführen, die kleiner ist als 8 ns. Dies ermöglicht ebenfalls den Erhalt der Anregung des Kommutierungsschwingkreises mit hohen Frequenzen und somit die Anregung des parasitären Schwingkreises und den Erhalt von geringen Überschwingungen nach Beendigung des Kommutierungsvorgangs.

Gemäß einem Ausführungsbeispiel weist der Halbleiterschalter einen Steueranschluss, beispielsweise einen Gate-Anschluss, auf, der mit der Ansteuereinrichtung verbunden ist. Ein Widerstandswert oder eine Impedanz (da auch der Gatekreis eine hohe parasitäre Induktivität besitzen kann) zwischen der Ansteuereinrichtung und dem Steueranschluss weist einen Wert von höchstens einem Ohm auf. Ein geringer oder gar minimaler Gatewiderstand ermöglicht den Erhalt von steilen Schaltflanken und mithin ebenfalls eine stufenförmige Anregung des Kommutierungsschwingkreises, unter anderem, durch kürzere Schaltdauern.

Gemäß einem Ausführungsbeispiel ist die Vorrichtung in Abwesenheit eines Gate-Vorwiderstandelements gebildet, so dass lediglich der Ausgangswiderstand der Ansteuereinrichtung, parasitäre Widerstände und Induktivtäten bzw. Impedanzen wirken, was hin zu einem möglichst geringen wirksamen Gatewiderstand führt und mithin zu geringen Überschwingungen und schnellen Schaltzeiten, d. h., kürzeren Schaltdauern führt.

Gemäß einem Ausführungsbeispiel wird der Kommutierungsschwingkreis durch den Schaltvorgang angeregt. Der Gleichspannungswandler weist einen Kommutierungskreis auf, der eine Freilaufdiode umfasst, wobei die Freilaufdiode wirksam ist, um eine Schwingung des Kommutierungsschwingkreises nach Ablauf der der Kommutierung zu beenden, so dass der Kommutierungsschwingkreis höchstens eine unvollständige Schwingung ausführt. Dies ermöglicht den Erhalt von geringen Überschwingungen.

Gemäß einem Ausführungsbeispiel ist der Halbleiterschalter ausgelegt, um in einem bestimmungsgemäßen Betrieb hart schalten, das bedeutet, während eines Stromflusses und während anliegender Spannung betrieben zu werden. Dies ermöglicht das Schalten des Schalters zu beliebigen Zeitpunkten während des Betriebs.

Gemäß einem Ausführungsbeispiel ist die Ansteuereinrichtung ausgebildet, um den Halbleiterschalter hart zu schalten. Dies ermöglicht die Einstellung möglichst optimaler Schaltzeitpunkte.

Gemäß einem Ausführungsbeispiel umfasst der Gleichspannungswandler eines aus einem Aufwärtswandler (Boost-Converter), einem Abwärtswandler (Buck-Converter), einem

Halbbrückenwandler, einem Vollbrückenwandler, einem invertierenden Wandler und einem Sperrwandler (Flyback-Converter). Das bedeutet, die erfindungsgemäße Ansteuerung ist auf beliebige Gleichspannungswandler übertragbar.

Gemäß einem Ausführungsbeispiel umfasst eine elektrische Schaltung eine Vorrichtung gemäß hierin beschriebener Ausführungsbeispiele und eine elektrische Spannungsquelle, die mit dem Halbleiterschalter gekoppelt ist, beispielsweise eingangsseitig oder ausgangsseitig. Die elektrische Spannungsquelle ist ausgebildet, um während eines Betriebs der Vorrichtung zeitweise eine elektrischen Spannung an den Gleichspannungswandler anzulegen, die zumindest 84% einer Sperrspannung eines Halbleiters entspricht. Alternativ oder zusätzlich ist der Gleichspannungswandler ausgebildet, um basierend auf einer von der elektrischen Spannungsquelle bereitgestellten elektrischen Eingangsspannung zeitweise eine elektrische Ausgangsspannung bereitzustellen, die zumindest 84% einer Sperrspannung eines Halbleiterschalters entspricht. Dies ermöglicht die Dimensionierung des Halbleiterschalters derart, dass er mit Spannungen von zumindest 84% der Sperrspannung (Maximalspannung im bestimmungsgemäßen Betrieb) betrieben wird. Das bedeutet, gemäß Ausführungsbeispielen kann auf eine übermäßige Überdimensionierung der Spannungsfestigkeit des Halbleiterschalters verzichtet werden, was zu geringen Anforderungen an Chipfläche, elektrischer Leistung, Bauvolumen und/oder Kosten führen kann.

Gemäß einem Ausführungsbeispiel umfasst eine Vorrichtung einen Gleichspannungswandler mit einer ersten Seite und einer zweiten Seite, zwischen denen eine Kommutierungszelle umfassend einem Halbleiterschalter und einem Freilaufelement angeordnet ist. Der Kommutierungskreis ist mit einer Stromquelle verbunden, die konfiguriert ist, um einen Phasenstrom für den Gleichspannungswandler bereitzustellen. Während eines Ruhezustandes des Halbleiterschalters liegt in der Kommutierungszelle eine Kommutierungsspannung an. Der Kommutierungskreis weist einen Kommutierungsschwingkreis umfassend eine elektrische Induktivität und eine elektrische Kapazität auf, wobei der Kommutierungsschwingkreis so gebildet ist, innerhalb eines Toleranzbereichs von 30 % gilt, dass

$$I_{PH} = \frac{2 U_{ZK} \sqrt{2\frac{C}{L}}}{\pi}$$

wobei $I_{RH}$ den Phasenstrom zum Schaltzeitpunkt, $U_{ZK}$ die Kommutierungsspannung, C die elektrische Kapazität und L die elektrische Induktivität beschreibt.

Weitere vorteilhafte Ausführungsformen sind in abhängigen Patentansprüchen definiert. Besonders bevorzugte Ausführungsbeispiele der vorliegenden Erfindung werden nachfolgend Bezug nehmend auf die beiliegenden Zeichnungen erläutert. Es zeigen:

Fig. 1   ein schematisches Blockschaltbild einer Vorrichtung gemäß einem Ausführungsbeispiel;

Fig. 2a   ein schematisches Blockschaltbild einer Vorrichtung gemäß einem weiteren Ausführungsbeispiel;

Fig. 2b   einen schematischen Graphen von elektrischen Größen der Vorrichtung aus Fig. 2a während eines Schaltvorganges und folgendem Kommutierungsvorgangs;

Fig. 3a   ein schematisches Blockschaltbild einer Simulationsgrundlage, einer Vorrichtung gemäß einem Ausführungsbeispiel, die parasitäre Eigenschaften aufweist;

Fig. 3b   ein schematisches Diagramm mit insgesamt 11 Kurven, die Simulationsergebnisse der Simulationsgrundlage aus Fig. 3a darstellen, gemäß Ausführungsbeispielen;

Fig. 3c   einen schematischen Graphen zur Verdeutlichung des Zusammenhangs zwischen einer Schaltdauer und den Überschwingungen in Vorrichtungen gemäß Ausführungsbeispielen;

Fig. 4a   einen schematischen Graphen mit Kurven, die Überschwingungen eines Gleichspannungswandlers mit verschiedenen Gatevorwiderständen darstellen, gemäß Ausführungsbeispielen;

Fig. 4b   einen schematischen Graphen einer Gegenüberstellung des Gatevorwiderstands gegenüber der erhaltenen maximalen Spannung, gemäß einem Ausführungsbeispiel;

Fig. 5a   ein schematisches Blockschaltbild eines Abwärtswandlers, der in Vorrichtungen gemäß Ausführungsbeispielen einsetzbar ist;

Fig. 5b   ein schematisches Blockschaltbild eines Halbbrückenwandlers, der in Vorrichtungen gemäß Ausführungsbeispielen einsetzbar ist;

Fig. 5c    ein schematisches Blockschaltbild eines invertierenden Wandlers, der in Vorrichtungen gemäß Ausführungsbeispielen einsetzbar ist;

Fig. 6a    ein schematisches Blockschaltbild eines Flyback-Wandlers, der in Vorrichtungen gemäß Ausführungsbeispielen einsetzbar ist;

Fig. 6b    einen schematischen Graphen mit einer Spannung an dem Halbleiterschalter des Wandlers aus Fig. 6a, gemäß einem Ausführungsbeispiel;

Fig. 7    ein schematisches Blockschaltbild einer elektrischen Schaltung gemäß einem Ausführungsbeispiel.

Fig. 8a    ein schematisches Blockschaltbild eines Gleichspannungswandlers gemäß dem Stand der Technik sowie einen schematischen Graphen mit einem Verlauf einer Spannung U und einem Strom I durch einen MOSFET; und

Fig. 8b    einen schematischen Graphen mit einem Verlauf einer Spannung und einem Strom durch einen MOSFET des Gleichspannungswandlers aus Fig. 8a.

Bevor nachfolgend Ausführungsbeispiele der vorliegenden Erfindung im Detail anhand der Zeichnungen erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgende Ausführungsbeispiele beziehen sich auf Gleichspannungswandler. Gleichspannungswandler können konfiguriert sein, um Gleichspannung mit einem ersten elektrischen Spannungslevel oder Potenzial auf ein zweites elektrisches Spannungslevel oder Potenzial umzusetzen, wobei das zweite Level größer oder kleiner sein kann als das erste Level. Gleichspannungswandler können einen Halbleiterschalter aufweisen, der von einer Ansteuereinrichtung geschaltet wird. Obwohl nachfolgende Ausführungsbeispiele so beschrieben sind, dass die darin beschriebenen Gleichspannungswandler MOSFET-Transistoren aufweisen, können alternativ oder zusätzlich auch andere Halbleiterschalter verwendet werden, beispielsweise Bipolartransistoren und/oder in einer anderen Fertigungstechnologie als MOS-gefertigte Transistoren.

Nachfolgende Ausführungsbeispiele beziehen sich auf Schaltvorgänge in Halbleiterschaltern. Diese sind im Rahmen der hierin beschriebenen Ausführungsbeispiele mit Kommutierungsvorgängen in Kommutierungskreisen der hierin beschriebenen Gleichspannungswandler verknüpft, das bedeutet, der Kommutierungsvorgang wird durch den Schaltvorgang ausgelöst. Insofern wird im Rahmen der hierin beschriebenen Ausführungsbeispiele synonym davon gesprochen, dass ein Schaltvorgang einen Erregerschwingkreis des Kommutierungskreises anregt und dass ein (durch den Schaltvorgang angestoßener) Kommutierungsvorgang den Erregerschwingkreis des Kommutierungskreises anregt.

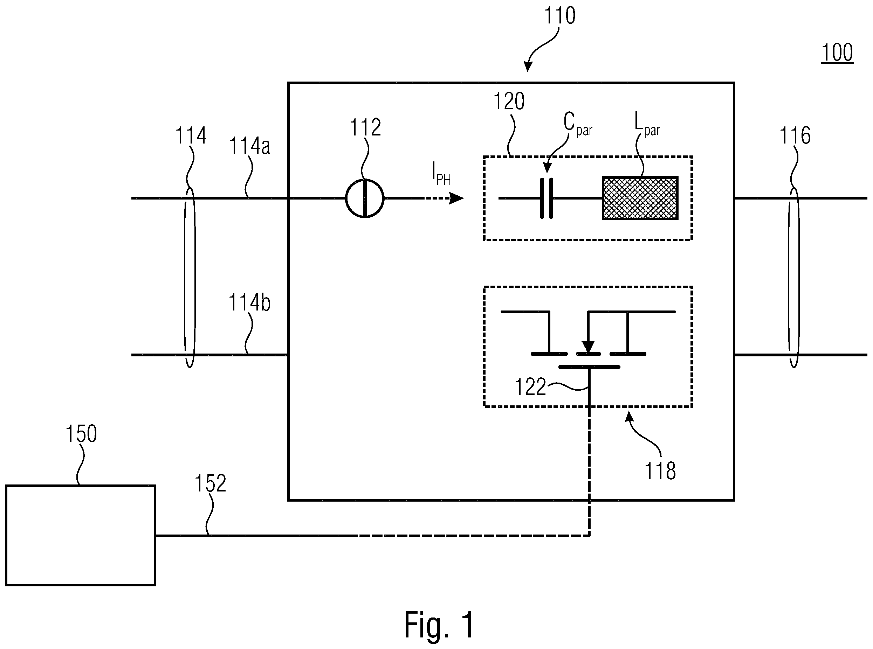

Fig. 1 zeigt ein schematisches Blockschaltbild einer Vorrichtung 100 gemäß einem Ausführungsbeispiel. Die Vorrichtung 100 umfasst einen Gleichspannungswandler 110 und eine Ansteuereinrichtung 150.

Der Gleichspannungswandler 110 umfasst eine Speicherdrossel 112, die beispielsweise mit einem Eingangsanschluss 114a oder 114b einer Eingangsseite 114 verbunden sein kann. Die Speicherdrossel wirkt als Stromquelle und ist konfiguriert, um den Phasenstrom $I_{PH}$ bereitzustellen. Anstelle einer Spule bzw. einer Drossel kann alternativ oder zusätzlich auch eine beliebige andere Stromquelle angeordnet sein. Gemäß alternativen Ausführungsbeispielen kann die Stromquelle bzw. die Speicherdrossel 112 auch mit einer Ausgangsseite 116 und/oder zwischen der Eingangsseite 114 und der Ausgangsseite 116 angeordnet sein.

Der Gleichspannungswandler 110 umfasst einen Halbleiterschalter 118, bei dem es sich um den Halbleiterschalter 1002 handeln kann, was jedoch nicht erforderlich ist. Der Schalter darf unbegrenzt schnell schalten und auch einen harten Stromabriss (snappy) besitzen. Wie es später verdeutlicht ist, bietet es Vorteile, den Halbleiterschalter 118 so auszuführen, dass er ausgelegt ist, um ihn einem bestimmungsgemäßen Betrieb, beispielsweise wie in einem Datenblatt beschrieben, hartschaltend betrieben zu werden. Insbesondere kann dadurch ein hart schaltender Abschaltvorgang des Schalters ermöglicht werden. Optional kann zusätzlich ein weiches Einschalten erfolgen. Das bedeutet, Ausführungsbeispiele beziehen sich auf eine Vorrichtung zum harten Ausschalten in Kombination mit einem weichen Einschalten (geringe Ströme und Spannungen). In hierin beschriebenen Ausführungsbeispiele können die erläuterten ZOS-Abschaltvorgänge auch als weich bezeichnen, nämlich als schnelles sogenanntes ZVS (Zero Voltage Switching), was eben durch die beschriebenen Kommutierungsschwingkreise ermöglicht wird, allerdings erfolgt ein Betrieb der Bauteile im Sinne eines harten Schaltens. Ausführungsbeispiele sind somit nicht auf die reine Ausführung zum harten Schalten beschränkt sondern können mit weichen Schaltvorgängen kombiniert werden. Der Betriebspunkt mancher hierin beschriebener Vorrichtungen kann an sich als hart schaltend verstanden werden, das ermöglichte Zero Overvoltage Switching kann dahingegen als Transformation zu weich schaltend in diesem Betriebspunkt verstanden werden. In Übereinstimmung hiermit kann die Ansteuereinrichtung 150 ausgebildet sein, um den Halbleiterschalter 118 hart zu schalten, das bedeutet, während eine relevante und/oder hohe Stromstärke und/oder Spannungsstärke an dem Bauteil anliegt.

Der Gleichspannungswandler 110 umfasst ferner einen Kommutierungsschwingkreis 120, der zumindest teilweise aus parasitären elektrischen Eigenschaften des Gleichspannungswandlers 110 gebildet sein kann. Hierzu zählen beispielsweise Leitungsinduktivitäten und/oder Streuinduktivitäten des Gleichspannungswandlers 110, die als $L_{par}$ beispielhaft bezeichnet sind. Alternativ oder zusätzlich kann der Kommutierungsschwingkreis 120 parasitäre kapazitive Eigenschaften aufweisen, die als $C_{par}$ beispielhaft gekennzeichnet sind und beispielsweise parallel zu dem Halbleiterschalter 118 wirkende Kapazitäten bezeichnen können. Der Kommutierungsschwingkreis 120 kann eine oder mehrere Resonanzfrequenzen aufweisen. Beispielsweise kann der Kommutierungsschwingkreis 120 während des Kommutierungsvorgangs als Serienschwingkreis umfassend einen Induktivitätswert L und einen Kapazitätswert C modelliert werden, so dass sich die Resonanzfrequenzen näherungsweise mit

$$\frac{1}{2\pi\sqrt{LC}}$$

angeben lässt. Gemäß weiteren Ausführungsbeispielen kann der Kommutierungsschwingkreis 120 als anders gearteter Schwingkreis, beispielsweise ein Parallelschwingkreis, modulierbar sein und/oder andere und weitere parasitäre Werte und/oder Bauelemente aufweisen, die den Erhalt eines resonanzfähigen Schwingkreises ermöglichen.

Schaltvorgänge des Halbleiterschalters 118 können dazu führen, dass der Kommutierungsschwingkreis 120 angeregt wird, was durch Änderungen in der anliegenden Spannung, Änderungen in dem Stromfluss durch den Schalter und/oder Änderungen von Spannungen und/oder Stromflüssen an anderen Elementen des Gleichspannungswandlers 110 zumindest teilweise verursacht sein kann. Gemäß Ausführungsbeispielen ist vorgesehen, Elemente des Kommutierungsschwingkreises 120 aneinander anzupassen. Zusätzlich können beispielsweise bekannte Schaltungen manche Elemente, etwa Gatewiderstände, weggelassen werden und/oder dass zu parasitären kapazitiven und/oder induktiven Eigenschaften des Gleichspannungswandlers 110 separate/diskrete und dimensionierte Bauelemente hinzugefügt werden, die in Kombination mit den parasitären Eigenschaften $C_{par}$ und/oder $L_{par}$ einen gewünschten elektrischen Kapazitätswert oder elektrischen Induktivitätswert einstellen.

Die Ansteuereinrichtung 150 ist mit einem Steueranschluss 122 des Halbleiterschalters 118 verbunden, beispielsweise mit einem Gate-Anschluss. Basierend auf einem Steuersignal 152, das von der Ansteuereinrichtung 150 an den Steueranschluss 122 übermittelt wird, kann der Halbleiterschalter 118 zwischen einem leitenden und einem nichtleitenden bzw. sperrenden Zustand geschalten werden.

Die Ansteuereinrichtung 150 ist konfiguriert, um den Schaltvorgang mit einer Schaltdauer auszuführen, die kleiner ist als eine Periodendauer einer Resonanzfrequenz des Kommutierungsschwingkreises.

Eine Resonanzfrequenz des Kommutierungsschwingkreises 120 kann von einer Periodendauer einer entsprechenden Resonanzfrequenz des Kommutierungsschwingkreises 120 beeinflusst sein. Die Ansteuereinrichtung kann nun konfiguriert sein, um die Schaltdauer sowohl einzustellen bzw. den Schaltvorgang mit einer entsprechenden Geschwindigkeit auszuführen, dass die Schaltdauer geringer ist als die Periodendauer. Hierbei sei angemerkt, dass für die Ausführung eines Schaltvorgangs mehrerer Definitionen bekannt sind, beispielsweise der Übergang des entsprechenden Werts (Gatespannung) von einem Maximalwert zu einem Minimalwert, von 90% des Maximalwerts zu 10% des Minimalwerts oder dergleichen. Für die hierin beschriebenen Ausführungsbeispiele soll als Schaltdauer diejenige Zeitdauer gelten, in welcher der Strom im aktiven Bereich des Halbleiterschalters von 90% des Phasenstromes auf 10% des Phasenstromes absinkt. Der aktive Bereich ist hierbei bspw. der physikalische Bereich, welcher bei anliegendem Strom und Spannung die Leistung in Wärme umsetzt. Davon ausgeschlossen sind z. B. Blindströme durch parasitäre Kapazitäten, welche an den externen Anschlüssen des Transistors einen Stromfluss auch außerhalb der Schaltzeitdefinition erlauben.

Ein beschriebener schneller Schaltvorgang mit einer geringen Schaltdauer ermöglicht eine breitbandige Anwendung des Kommutierungsschwingkreises 120 und mithin den Eintrag von Energie in den Kommutierungsschwingkreis 120.

Zusätzlich ist die Ansteuereinrichtung 150 ausgebildet, um einen Zeitpunkt des Schaltvorgangs so zu wählen, dass ein zum Zeitpunkt des Schaltvorgangs durch die Speicherdrossel 112 fließender Strom $I_{PH}$, d. h., ein von der Stromquelle bereitgestellter Strom, ein Überschwingen an dem Halbleiterschalter 118 von höchstens 30% bezogen auf einen Ruhezustand des Halbleiterschalters erzeugt. Gemäß weiteren vorteilhaften Ausführungsbeispielen ist die Ansteuereinrichtung 150 ausgebildet, um einen Zeitpunkt des Schaltvorgangs so zu wählen, dass der zum Zeitpunkt des Schaltvorgangs durch die Speicherdrossel (Stromquelle) 112 fließende Strom $I_{PH}$ ein Überschwingen an dem Halbleiterschalter 118 von höchstens 20 % oder höchstens 15% bezogen auf den Ruhezustand des Halbleiterschalters erzeugt. Die genannten Kriterien können sowohl für ein Einschalten als auch für ein Ausschalten des Halbleiterschalters 118 gelten. Als Ruhezustand kann beispielsweise der Sperrzustand des Halbleiterschalters 118 betrachtet werden, in welchen, verglichen mit anderen Betriebszuständen, eine maximale Spannung oder Zwischenkreisspannung an dem Halbleiterschalter 18 bzw. zwischen den Leistungsanschlüssen desselben, abfällt.

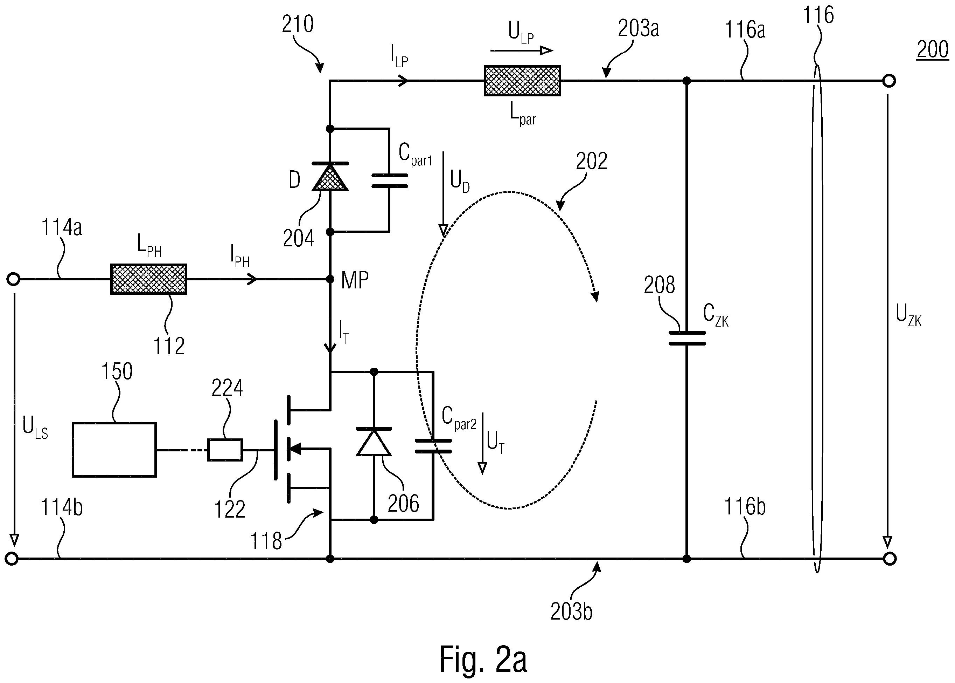

Fig. 2a zeigt ein schematisches Blockschaltbild einer Vorrichtung 200 gemäß einem Ausführungsbeispiel, auf die das im Zusammenhang mit der Vorrichtung 100 erläuterte zutrifft. Die Vorrichtung 200 umfasst einen Gleichspannungswandler 210 mit einer vergleichbaren Funktion, wie sie im Zusammenhang mit dem Gleichspannungswandler 110 beschrieben ist. Die parasitäre Induktivität $L_{par}$ ist als Element eines Kommutierungskreises 202 dargestellt. Die parasitäre Induktivität kann zumindest Teilweise, bevorzugt jedoch zu einem Hauptanteil von zumindest 50 %, zumindest 60 % oder zumindest 70 % in einer Verschienung, d. h., elektrischen Anschlussleitungen, 203a und 203b angeordnet oder enthalten sein. Die Anschlussleitungen 203a und 203b ermöglichen die elektrische Kontaktierung der ersten Seite 114, der zweiten Seite 116 und des Halbleiterschalters 118. Die parasitäre Induktivität kann unter anderem von einem Material der elektrischen Anschlussleitungen 203a und/oder 203b, von einem Abstand zwischen einzelnen Leitungen 203a und 203b und/oder von einer Geometrie derselben beeinflusst sein, etwa einem Querschnitt und/oder einer Länge und/oder einem axialen Verlauf, bspw. gerade, gekrümmt oder mäandriert. Es wird darauf hingewiesen, dass dies nicht notwendiger weise so verstanden werden soll, dass die parasitäre Induktivität $L_{par}$ ein identifizierbares oder eigenes oder speziell verbautes Bauelement ist. Ferner bedeutet die schematische Darstellung der Fig. 2a nicht, dass die parasitäre Induktivität $L_{par}$ nur an einer einzelnen Stelle angeordnet ist. Vielmehr kann es sich bei der parasitären Induktivität $L_{par}$ um eine verteilte Induktivität handeln, beispielsweise eine Streuinduktivität und/oder eine elektrische Induktivität, die durch eine elektrische Leitung oder im Zwischenkreiskondensator oder dergleichen zumindest teilweise wirksam ist. Das bedeutet, die schematische Darstellung der Fig. 2a soll nicht so verstanden werden, dass ein exakter Ort der parasitären Induktivität $L_{par}$ festgelegt sei.

Der Kommutierungskreis kann als Induktivitätswert L und Kapazitätswerte Cpar1 sowie Cpar2 modelliert werden, so dass sich die Resonanzfrequenzen näherungsweise mit

$$\frac{1}{2\pi\sqrt{L\dfrac{C_{par1}C_{par2}}{C_{par1}+C_{par2}}}}$$

angeben lässt. Nach dem Kommutierungsvorgang etwa kann eine Kapazität durch ein aktives Bauelement, z.B. durch ein Freilaufbauelement 204 kurzgeschlossen sein, so dass dies nicht mehr im Schwingkreis wirksam ist. Die Schwingkreisfrequenz des Kommutierungschwingkreises ändert sich somit z.B. auf

$$\frac{1}{2\pi\sqrt{LC_{par2}}}$$

Es sei angemerkt, dass Die Induktivität Lpar nicht oder nur in einem geringen Umfang zwischen den aktiven Bauteilen 204 und 118 wirksam ist sondern abseits hiervon, bspw. an den Zuleitungen. Das bedeutet, dass die Induktivität bevorzugt nicht zwischen den beiden aktiven Bauelementen, d.h., dem Freilaufelement 204 und dem Halbleiterschalter 118, wirksam ist, sondern im Pfad um die Bauelemente, z. B. über die Anschlüsse der Halbbrücke oder im Pfad des Zwischenkreiskondensators. Des Weiteren kann $L_{par}$ auch durch ein diskretes Bauteil erhöht werden um auf gewünschte Kommutierungskreisinduktivitätswerte zu kommen. Des Weiteren können die elektrischen Leiter so ausgestaltet werden, dass diese einen gewünschten parasitären Induktivitätswert aufweisen, z.B. durch größere Abstände zwischen den Leitern.

Basierend auf den unterschiedlichen Zuständen des Schalters kann der Kommutierungsschwingkreis durch unterschiedliche Elemente hinsichtlich seiner Resonanzfrequenz bestimmt sein. Die Resonanzfrequenz kann somit bei Asymmetrie des Kommutierungsschwingkreises 202 zeitlich veränderlich sein. So kann zu einem ersten Zeitpunkt, in welchem der Strom über das Freilaufelement 204 läuft, von der Kapazität $C_{par1}$ beeinflusst sein sowie von demjenigen Anteil der parasitären Induktivität $L_{par}$, die entlang dieses Pfades angeordnet ist. Zu einem zweiten Zeitpunkt, in welchem der Strom bspw. über den Schalter 118 läuft, kann die Resonanzfrequenz von der Kapazität $C_{par2}$ beeinflusst sein sowie von demjenigen Anteil der parasitären Induktivität $L_{par}$, die entlang dieses anderen Pfades angeordnet ist.

Die parasitäre Induktivität Lpar soll so verstanden werden, dass sie einen Teil des Kommutierungskreises 202 bildet. Der Kommutierungskreis 202 weist ferner ein Freilaufelement 204 auf, die mit dem Symbol D versehen ist. Bei dem Freilaufelement 204 kann es sich bspw. um eine Freilaufdiode, um einen Freilaufpfad, um ein Freilaufbauelement, um einen Transistor, um eine Diode und/oder eine Bodydiode handeln. Parallel zu dem Freilaufelement 204 kann eine parasitäre elektrische Kapazität $C_{par1}$ wirken. Diese parasitäre Kapazität kann mit der parasitären Induktivität $L_{par}$ zumindest einen Teil eines Serienschwingkreises bilden. Das Freilaufelement 204 kann als eigenständiges Bauteil implementiert sein, kann aber auch Bestandteil zumindest eines Transistors sein und bspw. als Bodydiode ausgeführt sein.

Alternativ oder zusätzlich kann parallel zu dem Halbleiterschalter 118 eine eigens angeordnete oder parasitäre Diode 206 angeordnet sein, wobei parallel zu der Diode 206 eine parasitäre Kapazität $C_{par2}$ wirken kann, die somit ebenfalls parallel zu dem Halbleiterschalter 118 wirken kann. Auch in Abwesenheit der Diode 206 kann die parasitäre Kapazität $C_{par2}$ parallel zu dem Halbleiterschalter 118 wirken. Der Kommutierungsschwingkreise kann zum Teil der Kommutierungszelle des Gleichspannungswandlers 210 sein.

Ferner kann der Kommutierungskreis 202 einen Zwischenkreiskondensator 208, der mit $C_{ZK}$ bezeichnet ist, aufweisen. Über den Zwischenkreiskondensator 208 kann eine Ausgangsspannung $U_{ZK}$ an der Ausgangsseite 116 abfallen.

Die Vorrichtung 200 kann einen Gatevorwiderstand 224 aufweisen, der zwischen der Ansteuereinrichtung 150 und den Steueranschluss 112 geschaltet ist. Der Gatevorwiderstand kann diskrete Elemente und/oder parasitäre Eigenschaften aufweisen und kann bewirken, dass ein Schaltvorgang des Halbleiterschalters 118 eine endlich kurze Zeitspanne erfordert.

Die Speicherdrossel 112 kann mit dem Kommutierungskreis elektrisch gekoppelt sein und bspw. zwischen den Anschluss 114a und den Kommutierungskreis 202 gekoppelt sein. Sie Stromquelle kann so verschaltet sein, dass eine erste Seite direkt oder indirekt mit dem Eingangsanschluss 114a gekoppelt ist und eine zweite Seite der Speicherdrossel 112 zwischen einen Leistungsanschluss des Halbleiterschalters 118 und das Freilaufelement 204 gekoppelt ist, wobei ein derartiger Koppelort mit MP (Mittelpunkt/midpoint) bezeichnet ist. Der Punkt MP kann einen Mittenabgriff eines kapazitiven Spannungsteilers bilden, der durch die parasitären Kapazitäten $C_{par1}$ und $C_{par2}$ zumindest teilweise gebildet wird. Das heißt, es kann gelten, dass eine Spannung $U_D$, die über der Diode bzw. über der parasitären Kapazität $C_{par1}$ abfällt zusammen mit einer Spannung $U_T$, die über dem Halbleiterschalter 118 bzw. der parasitären Kapazität $C_{par2}$ abfällt gleich der Spannung $U_{ZK}$ ist, die über dem Kommutierungskondensator abfällt, d. h., es kann im stationären Fall gelten, dass:

$$U_D + U_T = U_{ZK}$$

Das bedeutet, dass die Kommutierungsspannung $U_{ZK}$ eine über der Kommutierungszelle bzw. den darin angeordneten elektrischen Elementen abfallende Spannung sein kann. Wie es in Fig. 2a ersichtlich ist, kann während des Kommutierungsvorganges eine Spannung $U_{LP}$ über die Induktivität des Kommutierungsschwingkreises zusätzlich einwirken.

Es wird angemerkt, dass diese Betrachtung für den Schaltfall, also im Falle der resonanten Schwingung, um die über der parasitären Induktivität $L_{par}$ abfallende Spannung ergänzt werden kann. Der Strom $I_{PH}$ kann somit als Summe der Ströme $I_{LP}$ durch die parasitäre Induktivität $L_{par}$ und einen Strom $I_T$ durch den Transistor 118 beschrieben werden, d. h., es kann gelten:

$$I_{PH} = I_{LP} + I_T$$

Eine Spannung $U_{LS}$ an der Eingangsseite kann zum Fließen des Stroms $I_{PH}$ zumindest teilweise beitragen.

Gemäß einem Ausführungsbeispiel sind die elektrischen Kapazitätswerte der parasitären Kapazitäten Cpar1 und Cpar2 innerhalb eines Toleranzbereichs von 30%, bevorzugt 20% und noch mehr bevorzugt 10% gleich. Alternativ hierzu sind die insgesamt wirkenden Kapazitätswerte gleich, wobei die insgesamt wirkenden Kapazitätswerte an der Stelle $C_{par1}$ und $C_{par2}$ durch eine Kombination der parasitären Kapazität mit einem kapazitiven Bauteil verstanden werden kann. Das bedeutet, eine Ungleichheit zwischen den parasitären Kapazitäten kann durch ein zusätzliches Bauelement ausgeglichen werden, um eine Symmetrie herzustellen, so dass innerhalb des Toleranzbereichs gilt, dass Cpar1 = Cpar2.

In anderen Worten, unter der Annahme, dass Cpar1, Cpar2 und die verteilte Induktivität Lpar ideal sind, also linear und nicht verlustbehaftet seien, kann für das Zero Overvoltage -Schalten gemäß Ausführungsbeispielen gelten, dass die Kapazitäten $C_{par1}= C_{par2}= C_{par}$. Der Phasenstrom $I_{PH}$ ändert sich näherungsweise aufgrund der hohen Induktivität von $L_{PH}$ aufgrund des Schaltvorgangs nicht. Für den Strom kann für das ZOS-Schalten folgender Zusammenhang festgelegt werden:

$$I_{PH} = \frac{2U_{ZK}\sqrt{2\dfrac{C_{par}}{L_{par}}}}{\pi}$$

Es ergibt sich dadurch auch eindeutig und unmittelbar, dass durch Umstellen der Formel auch eine Vorschrift für die Auslegung der Komponenten und/oder parasitären Eigenschaften wie z.B. $L_{par}$, $C_{par}$, in Abhängigkeit von gewünschtem Strom und/oder gewünschter Spannung am Schaltpunkt erhalten werden können.

Angemerkt sei, dass obige Formel den gesuchten Strom bei linearen Kapazitäten beschreibt. Schaltende Halbleiterelemente wie Transistoren können jedoch einen stark nichtlinearen Kapazitätsverlauf aufweisen. Hierbei kann der gesuchte Strom numerisch oder durch Simulation ermittelt werden oder eine geeignete lineare Ersatzkapazität $C_{par}$ für die Berechnung angewendet werden.

Insbesondere ist es gemäß Ausführungsbeispielen der Erfindung vorgesehen sein, eine Vorrichtung so auszugestalten, dass sie obige Gleichung innerhalb eines Toleranzbereichs von 30 %, 20 % oder 10 % oder exakter erfüllt. Die Vorrichtung kann einen Gleichspannungswandler aufweisen. Dieser kann eine erste Seite, etwa die Seite 114 und eine zweite Seite, etwa die Seite 116, aufweisen, zwischen denen eine Kommutierungszelle angeordnet ist. Diese kann einen Halbleiterschalter, etwa den Halbleiterschalter 118 und ein Freilaufelement, etwa das Freilaufelement 204 umfassen. Der Kommutierungskreis ist mit einer Stromquelle, etwa der Stromquelle 112 verbunden, d. h., elektrisch gekoppelt, die konfiguriert ist, um den Phasenstrom $I_{PH}$ für den Gleichspannungswandler bereitzustellen. Während eines Ruhezustandes des Halbleiterschalters liegt in der Kommutierungszelle eine Kommutierungsspannung ($U_{ZK}$) an. Der Kommutierungskreis umfasst einen Kommutierungsschwingkreis, etwa den Kommutierungsschwingkreis 202, das bedeutet parasitäre Kapazitäten und Induktivitäten und optional auch weitere, ggf. diskrete kapazitive und/oder induktive Elemente, um den Erregerschwingkreis anzupassen. Hierbei können die optionalen zusätzlichen Elemente, insbesondere die induktiven Elemente auch über eine spezielle Anpassung der Verschienung (Anschlussleitungen) und/oder der anderer Anschlusselemente des Halbleiterschalters erfolgen, etwa indem magnetische oder ferromagnetische Materialien in ein Material der Anschlussschienen oder Anschlussleitungen eingebracht wird und/oder deren Querschnitt oder Länge angepasst wird. Der Kommutierungsschwingkreis ist so gebildet ist, dass innerhalb des Toleranzbereichs gilt, dass

$$I_{PH} = \frac{2U_{ZK}\sqrt{2\frac{C}{L}}}{\pi}$$

wobei $I_{PH}$ den Phasenstrom zum Schaltzeitpunkt, $U_{ZK}$ die Kommutierungsspannung, C die elektrische Kapazität und L die elektrische Induktivität beschreibt. Hierbei handelt es sich um ein mit den anderen hierin offenbarten Beispielen verknüpftes Ausführungsbeispiel. Die jeweiligen Erläuterungen sind untereinander austauschbar und kombinierbar, das bedeutet, die Anpassung des Kommutierungskreises sowie die hinreichend schnelle Ansteuerung können als einander ergänzende Ausdrucksweisen derselben Erfindung verstanden werden. Im symmetrischen Fall kann gelten, $C_{par1} = C_{par2} = C_{par} = C$.

In weiter anderen Worten zeigt Fig. 2a eine ZOS-Schaltung (ZOS = Zero Overvoltage Switching), wobei die Ansteuereinrichtung 150 ausgebildet ist, um eine ZOS-Betriebsart zu implementieren, auf die nachfolgend eingegangen wird. Die ZOS-Schaltung zeichnet sich u. a. durch eine oder mehrere der folgenden Eigenschaften aus:

- Hinzufügen oder Vergrößern einer Induktivität im Kommutierungskreis 202, das bedeutet, die Induktivität ist frei einstellbar;
- Hinzufügen oder Vergrößern einer oder mehrerer Parallel-Kapazitäten der schaltenden Elemente (etwa Transistoren oder Dioden), das bedeutet, die Parallel-Kapazitäten sind frei einstellbar;

- Entfernen oder Reduzieren der Gate-Vorwiderstände und Gate-Zuleitungsimpedanzen, um hohes oder gar maximal schnelles Schalten zu ermöglichen, das bedeutet, die Gatevorwiderstände sind beliebig dimensionierbar und insbesondere beliebig gering dimensionierbar; und
- ein Einsatz von beliebig schnell schaltenden oder mit typisch hartem Stromabriss arbeitenden snappy Bauelementen ist möglich, welche ein hartes Abschalten des Stroms verursachen und gemäß bekannten Konzepten für einen Kommutierungskreis nur mit hohem Aufwand einsetzbar wären.

Die ZOS-Betriebsart zeichnet sich durch eine oder mehrere dieser Eigenschaften aus:

- die ZOS-Kommutierungsvorgänge sind "hart", d. h. das Abschalten erfolgt gleichzeitig bei hohem Strom und hoher Spannung;
- die ZOS-Betriebsart regelt Pulse und Ströme derart, dass Kommutierungsvorgänge beim Abschalten in einem bestimmten Verhältnis oder Zusammenhang von Strom und Spannung zueinander auftreten, d. h., dass der Zeitpunkt des Schaltvorgangs so gewählt wird, dass ein durch die Speicherdrossel fließender Strom ein Überschwingen an dem Halbleiterschalter von höchstens 30%, bevorzugt höchstens 20% und weiter bevorzugt von höchstens 10% bezogen auf den Ruhezustand des Halbleiterschalters erzeugt. Die von der Ansteuereinrichtung 150 genutzten Arbeitspunkte stellen daher eine Untermenge der möglichen Arbeitspunkte in einem vergleichsweise kleinen Feld von Strom und Spannung dar, wobei in Bezug auf den Strom und/oder die Spannung Toleranzwerte von $\pm$ 30%, $\pm$ 15%, $\pm$ 10% oder $\pm$ 5% als maximale Begrenzungen anlegbar sind;
- zumindest einige der Arbeitspunkte abseits der ZOS-Arbeitspunkte können zu unzulässig hohen Überspannungen und/oder Abschaltenergien und/oder starken Oszillationen führen. Dies wird gemäß der Arbeitsweise der Ansteuereinrichtung vermieden.

Hierzu wird gemäß einer Auslegung hierin beschriebener Ausführungsbeispiele der Kommutierungskreis 202 so gebildet, dass Bauelemente oder als solche wirkende Eigenschaften $C_{par1}$, $C_{par2}$ und $L_{par}$ hinzugefügt, erweitert und/oder ausgenutzt werden. Hiermit wird der Kommutierungsschwingkreis zumindest teilweise gebildet. Der Kommutierungsschwingkreis ist entlang der Kommutierungszelle bzw. des Kommutierungskreises 202 angeordnet. Der Schaltvorgang regt die parasitären und/oder zusätzlich eingebrachten Elemente derart an, dass der sich aus diesen Elementen bildende Schwingkreis besonders vorteilhaft für den Schaltvorgang oszilliert. Die Oszillation wird nach Beendigung des Schaltvorgangs durch die aktiven Bauteile, etwa das Freilaufelement 204, selbständig gestoppt oder zumindest auf eine kleine Amplitude reduziert. Um den Kommutierungsschwingkreis überhaupt anzuregen wird der Schaltvorgang mit einer gewissen Geschwindigkeit bzw. Schaltdauer oder sogar so schnell wie möglich ausgeführt. Eine zugrunde liegende Idealform kann eine Stufenform (näherungsweise unendlich steile Flanke) darstellen. Zunehmend steile Flanken ermöglichen die Anregung zunehmend hoher Frequenzen mit zunehmenden Amplituden. Dies funktioniert jedoch ohne Einschränkung auch in einer so gewählten langsamen bzw. schnellen Geschwindigkeit wie es reale Bauteile ermöglichen.

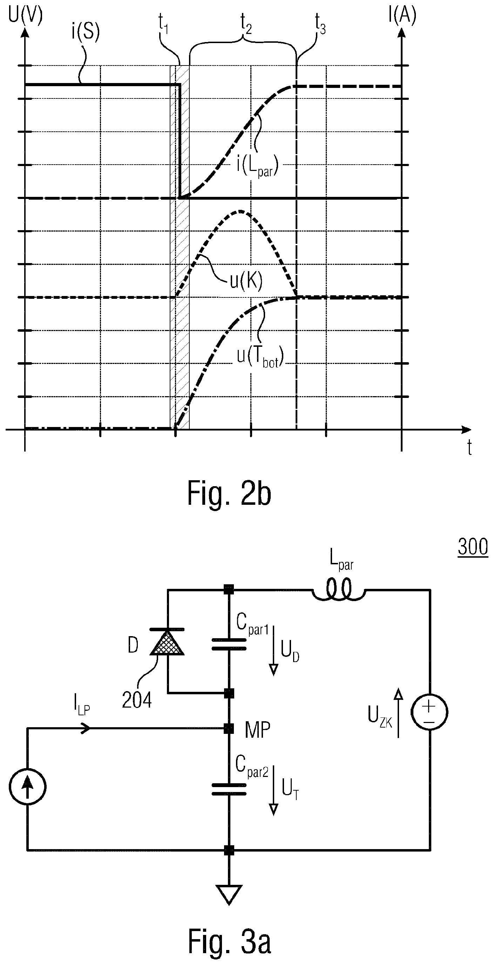

Schaltet der Halbleiterschalter 118 beispielsweise ab, etwa stufenförmig, so beginnt der Laststrom $I_T$ ab dem Moment des Abschaltens die parasitäre oder hinzugefügte Kapazität $C_{par2}$ aufzuladen, wie es bspw. in Fig. 2b dargestellt ist, siehe Zeitpunkt $t_1$. Das bedeutet, zum Zeitpunkt $t_1$ erfolgt ein Abschalten des Halbleiterschalters 118. Dadurch erhöht sich nachfolgend bis zum Zeitpunkt $t_2$ das Potential u(K) an der Kathode der Diode bzw. am Punkt K des oberen Freilaufelementes 204. Das verursacht einen zunehmenden Strom $i(L_{par})$ durch die parasitäre Induktivität $L_{par}$. Der Schwingkreis aus $C_{par2}$, $C_{par1}$ und $L_{par}$ wird angeregt. Durch die Kommutierung des Stromes auf $L_{par}$ wird $C_{par2}$ entladen. Angeregte Oszillationen enden nach einer halben Periodendauer zum Zeitpunkt $t_3$, wenn der Strom $i(L_{par})$ maximal ist.

Gemäß dem Ausführungsbeispiel führt der Schwingkreis dazu, dass das Potential am Punkt MP idealerweise auf das höhere Potential $U_{ZK}$, die Kommutierungsspannung, schwingt. In diesem Schwingkreis stellt sich idealerweise durch die korrekte Dimensionierung und einstellen des idealen Stromes in dem Moment nach dem Umschwingen des Potentials MP auch der passende Laststrom $I_T = I_{PH}$ in der parasitären Induktivität $L_{par}$ ein. Durch das Freilaufelement wird diese Oszillation wieder unterbrochen und der Wandler möglichst in den stationären Zustand überführt. Obwohl der Strom in $L_{par}$ überschwingen kann, um das gewünschte Ziel zu erreichen, ist dies nicht zwingend erforderlich.

Gemäß einem Ausführungsbeispiel erfolgt die Kommutierung des Stroms vom Halbleiterschalter 118 auf die Diode 204 bereits während des Anstiegs des MP-Punkts, ohne dass hierbei den Toleranzbereich überschreitende Überspannungen auftreten und/oder bleibende Oszillationen auftreten.

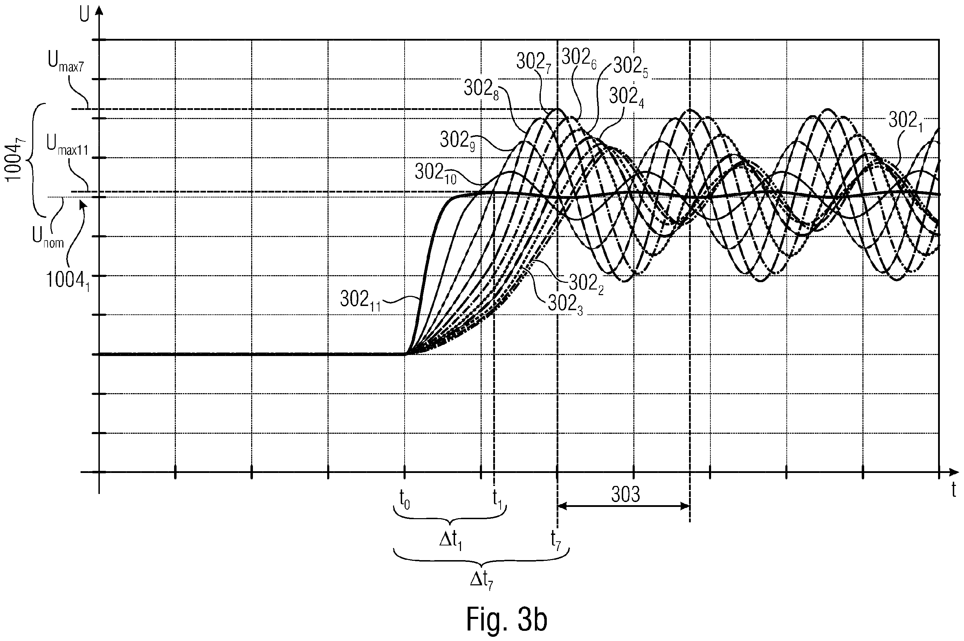

Anhand der Fig. 3a und 3b wird die Wahl der Flankensteilheit, das bedeutet, der Dauer des Umschaltens erläutert. Hierfür zeigt Fig. 3a ein schematisches Blockschaltbild einer Simulationsgrundlage 300, die die parasitären Eigenschaften $L_{par}$, $C_{par1}$ und $C_{par2}$ aufweist, wobei der Strom $I_{LP}$ und die Kommutierungsspannung $U_{ZK}$ beispielsweise durch simulierte Strom- bzw. Spannungsquellen eingeprägt werden. Die Werte für $C_{par1}$ und $C_{par2}$ wurden beispielhaft mit 100 pF und der Wert für $L_{par}$ mit 20 nH festgelegt.

Fig. 3b zeigt ein schematisches Diagramm mit insgesamt 11 Kurven $302_1$ bis $302_{11}$, die eine an der Ordinate angetragene Spannung U über die Abszisse Zeit bzw. t darstellen. Die Kurven $302_1$ bis $302_{11}$ können als Ergebnisse eines Schaltens eines Halbleiterschalters, beispielsweise des Halbleiterschalters 118 in der Vorrichtung 100 oder 200 verstanden werden, die beispielhaft in der Simulation gemäß der Fig. 3b bestimmt wurden. Die Kurven $302_1$ bis $302_{11}$ zeigen Schaltvorgänge, die mit einer unterschiedlichen Geschwindigkeit $\Delta t_{schalt}$ ausgeführt wurden, wobei sämtliche Kurven $302_1$ bis $302_{11}$ zu einem Zeitpunkt $t_0$ einen Beginn des Umschaltvorgangs des Halbleiterschalters anzeigen. Die Kurven $302_1$ bis $302_{11}$ sind in der genannten Reihenfolge mit abnehmenden Schaltzeiten bestimmt, wobei der Kurve $302_1$ beispielsweise eine Schaltzeit von 20 ns zugrunde liegen kann, der Kurve $302_7$, die den worst case (schlimmster Fall) darstellt, eine Schaltzeit von in etwa 8,88 ns zugrunde liegen kann, der Kurve $302_9$ eine Schaltzeit von 5 ns zugrunde liegen kann, der Kurve $302_{10}$ eine Schaltzeit von 3 ns zugrunde liegen kann und der Kurve $302_{11}$ eine Schaltzeit von 1 ns zugrunde liegen kann. Dementsprechend sinkt mit steigendem Kurvenindex eine Zeit $\Delta t$ bis zum Erreichen eines Maximums der Schwingungsamplitude. Die Kurven $302_i$ zeigen angeregte Oszillationen, die unterschiedliche Phasenlagen und/oder Amplituden bei gleicher Periodendauer 303 aufweisen können.

Es wird deutlich, dass mit abnehmender Schaltzeit eine Zunahme der Überschwingungen $1004_i$ erfolgt, bis der worst case in Kurve 7 erreicht ist. Die steht in Übereinstimmung mit bekannten Konzepten. Überraschenderweise wurde festgestellt, dass bei Unterscheiden der worst case-Schaltzeit eine erneute Abnahme der Überschwingungen 1004 erfolgt, die mit zunehmender Abnahme der Schaltzeit eine zunehmende Reduzierung der Überschwingungen 1004 ermöglicht.

Während des Schaltvorgangs ergibt sich eine Resonanzfrequenz welche durch die Reihenschaltung beider parasitärer Kapazitäten gegeben ist. Außerhalb des Kommutierungsvorgangs beim Ein- oder Abschalten, sobald eine der zwei identischen Kapazitäten $C_{par1}$ = $C_{par2}$ = Cpar durch ein aktives Bauelement kurzgeschlossen ist, ergibt sich eine zweite Resonanzfrequenz mit einer Periodendauer von

$$t_{ZOS,limit} = \frac{1}{2\pi\sqrt{LC_{par}}}$$

ein Wert von 8,886 ns, was der worst case Betrachtung entsprechen kann, so dass eine kritische Schaltzeit von $t_{ZOS\_limit}$ mit genau dieser Periodendauer $t_{ZOV,limit}$ angegeben werden kann. Bei Unterschreiten dieses Werts mit der Schaltzeit kann eine Reduzierung der Überschwingungen 1004 erhalten werden. Das bedeutet für eine vorteilhafte Amplitude der Überschwingungen an als Ergebnis für die Schaltzeit ein beliebiger Wert zwischen null (Nanosekunden) und maximal $t_{ZOS\_limit}$ erhalten werden, weil die Schaltzeit beispielsweise kleiner ist als die Hälfte der oben bestimmten Periodendauer des Resonanzfrequenz des Kommutierungsschwingkreises. Gemäß Ausführungsbeispielen ist die Ansteuerrichtung dementsprechend ausgebildet, um den Schaltvorgang mit einer Schaltzeit zu führen, die kleiner ist als 8 ns.

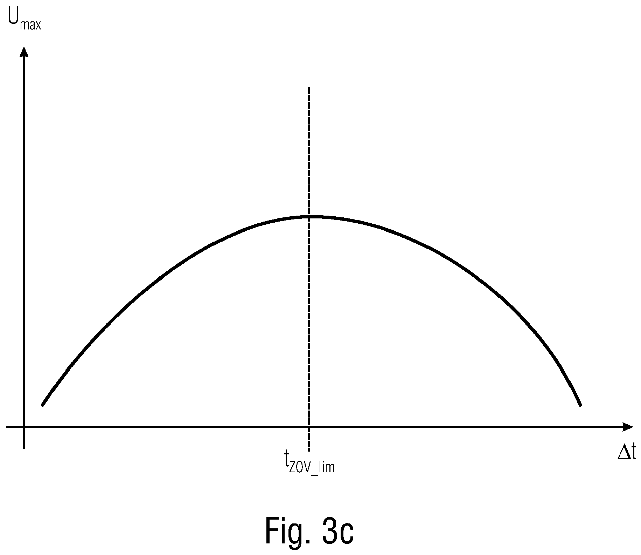

Fig. 3c zeigt einen schematischen Graphen zur Verdeutlichung des Zusammenhangs zwischen der Schaltzeit $\Delta t$ und den Überschwingungen im Sinne eines Betrags der Überspannung $U_{max}$. Die Ansteuereinrichtung 150 ist ausgebildet, um den Schaltvorgang mit einer Schaltdauer auszuführen, die kleiner ist als eine Periodendauer einer Resonanzfrequenz des Kommutierungsschwingkreises, somit mit einer Zeit, die maximal der Zeit $t_{ZOS\_lim}$ beträgt.

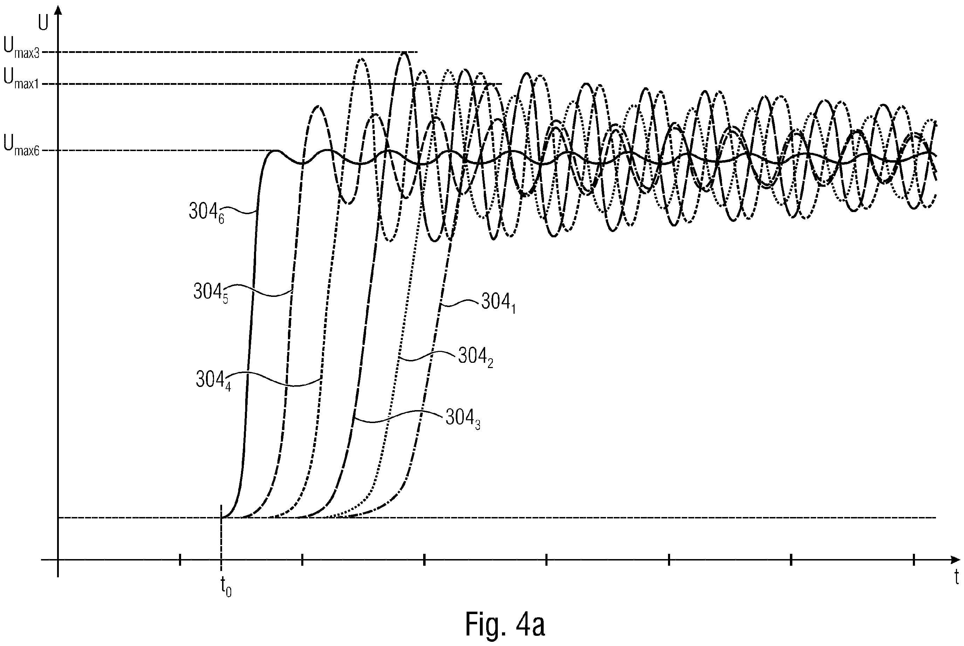

Fig. 4a zeigt einen schematischen Graphen mit Kurven $304_1$ bis $304_6$, die Überschwingungen $U_{max}$ - $U_{nom}$ eines beispielhaften Gleichspannungswandlers mit verschiedenen Gatevorwiderstände darstellen und Simulationsergebnisse der vorangehenden Erläuterungen sind. Gemäß Ausführungsbeispielen wird der Kommutierungschwingkreis durch den Schaltvorgang angeregt. Der Gleichspannungswandler weist gemäß diesem Ausführungsbeispiel einen Kommutierungskreis auf, der ein Freilaufelement umfasst, beispielsweise das Freilaufelement 204. Die Freilaufdiode 204 ist bspw. wirksam um einerseits einen Freilaufpfad für den Laststrom zu bieten, und um andererseits das Umpolen von $C_D$ zu verhindern und somit die Oszillation zu stoppen. Die Aktivierung der Freilaufdiode 204 ändert zudem den Kommutierungschwingkreis, da durch das Leiten der Freilaufdiode 204 die Kapazität CD überbrück, also wirkungslos geschaltet wird.

Der Schwingkreis aus CT, CD und Lpar führt demnach idealerweise während des Kommutierungsvorgangs nur eine Teilschwingung aus, welche aus der Überlagerung des Aufladens des Punktes MP durch den Laststrom $I_{PH}$ und der angeregten Oszillation besteht.

Mit zunehmender Schaltzeit bzw. abnehmender Schaltgeschwindigkeit führt der Kommutierungsschwingkreis eine zunehmend vollständigere Schwingung aus. Die Schwingzeit kann in Abhängigkeit der Schaltdauer auch mehr als eine Schwingungsdauer betragen, was jedoch zu zunehmend höheren Abschaltüberspannungen und zunehmend hohen anschließenden parasitären Oszillationen führt.

An der Abszisse ist die Zeitachse t dargestellt, die Ordinate bezeichnet die auftretende Spannung U. Mit zunehmendem Kurvenindex i = 1, ...,6 der Kurven $304_i$ reduziert sich der Gatevorwiderstand von beispielsweise 10 Ohm in Kurve $304_1$ bis hin zu 0 Ohm bei Kurve $304_6$. Während bei einem ersten Widerstandswert, beispielsweise 10 Ohm, der Kurve $304_1$ ein möglicherweise vertretbares Maß an Überschwingungen, das durch die maximale Amplitude $U_{max1}$ repräsentiert sein kann, erhalten werden kann, kann eine Abnahme des Gatevorwiderstands, wie in den Kurven $304_2$ und $304_3$ ersichtlich, zu einer Erhöhung der maximalen Amplitude führen, was auch in der abnehmend verschliffenen Flanke begründet ist. Dies wird auch dadurch deutlich, dass die Umschaltvorgänge mit abnehmendem Gatevorwiderstand ausgehend von dem Zeitpunkt $t_0$ rascher erfolgen.

Überraschenderweise wurde nun festgestellt, dass bei Unterschreiten eines bestimmten Werts des Gatevorwiderstands wieder eine Abnahme der Überschwingungen erfolgt, wie es in den Kurven $304_1$ bis $304_6$ ersichtlich ist, wobei eine zunehmende Abnahme des Gatevorwiderstands zu einer zunehmenden Abnahme der Überschwingungen führen kann. Da Gatevorwiderstände in der Regel zum Verschleifen der Schaltflanken, d. h., zur künstlichen Verzögerung eingesetzt werden, kann die Lehre der Fig. 4a auch darin gesehen werden, dass auf die Anordnung zusätzlicher Gatevorwiderstände verzichtet werden kann und sogar parasitäre Gatevorwiderstände vermieden werden können, um Verluste bezüglich der Zeit oder der Schaltleistung zu vermeiden. Ein Widerstandswert zwischen einer idealen Ansteuereinrichtung und dem Steueranschluss von Halbleiterschaltern in Vorrichtungen gemäß Ausführungsbeispielen kann deshalb ein Wert von höchstens einem Ohm aufweisen, bevorzugt höchstens 0,5 Ohm oder 0,1 Ohm. Bei einer nicht-idealen Steuereinrichtung kann dieser Widerstandswert bereits der Ausgangswiderstand der Einrichtung sein, z.B. der Ausgangswiderstand einer Gate-Treiber-Schaltung. Insbesondere können in vorteilhafter Weise Vorrichtungen gebildet werden, die in Abwesenheit eines separat angeordneten Gatevorwiderstandselements gebildet sind.

In anderen Worten zeigt die Fig. 4a ein Ergebnis von Simulationen und Vorrichtungen gemäß Ausführungsbeispielen mit typischen Bauteilen, typischen Induktivitäten, Strömungen und Spannungen. So wurden beispielsweise SiC-Elemente, beispielsweise Dioden, angenommen sowie eine Resonanzinduktivität, d. h., eine parasitäre Induktivität von 20 nH angenommen, wie sie beispielsweise in einem normalen Modulgehäuse auftreten kann. Es wurde eine Variation des Gatewiderstands von null Ohm bis 10 Ohm vorgenommen, wobei ein interner Vorwiderstand in dem Halbleiterschalter vorhanden war. Als Schaltstrom wurden beispielsweise 86 Ampere angenommen. Die Zwischenkreisspannung wurde mit 800 V angenommen. Die Kurven zeigen drastische Reduzierungen der Verluste und der Überspannung durch schnelleres Abschalten, wobei das schnellere Abschalten auch durch die abnehmenden Gatevorwiderstände ermöglicht wird. Gemäß Ausführungsbeispielen wird hierfür eine Anpassung der parasitären Eigenschaften und/oder der Bauelemente vorgenommen, was eine Angleichung der parasitären Kapazitäten und/oder eine Anpassung der parasitären Induktivitäten umfassen kann, so dass eine ZOS-Schaltung aufgebaut wird. Ferner kann ein geeigneter ZOS-Betrieb durch die Auswahl des Arbeitspunkts ermöglicht werden.

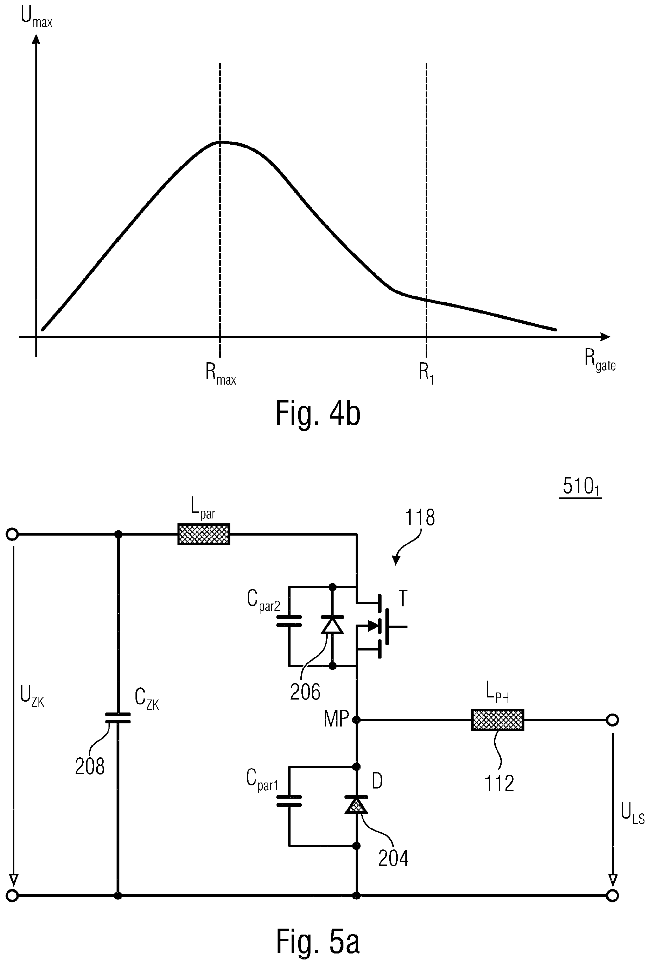

Fig. 4b zeigt einen schematischen Graphen einer Gegenüberstellung des Gatevorwiderstands $R_{gate}$, der an der Abszisse angetragen ist, gegenüber der erhaltenen maximalen Spannung $U_{max}$, die an der Ordinate angetragen ist. Gemäß dem Stand der Technik ist es üblich einen Gatevorwiderstand im Bereich eines Widerstands $R_1$ zu verwenden, der einen geringen Wert der erhaltenen Überspannung ermöglicht, wie es beispielsweise in der Kurve $304_1$ in Fig. 4a dargestellt ist. Bei einer Zunahme des Widerstandswerts kann eine bspw. asymptotische Abnahme der Überspannung erhalten werden. Bei einer Abnahme oder Reduzierung dieses Gatevorwiderstands kann eine Zunahme der Überschwingungen beobachtet werden. Deshalb wird im Stand der Technik versucht, im Bereich des Gatevorwiderstands $R_1$ zu bleiben oder diesen möglichst groß auszuführen. Erfindungsgemäß wurde erkannt, dass bei Unterschreiten eines Gatevorwiderstands $R_{max}$ eine erneute Abnahme der Überschwingungen erhalten werden kann, wobei dies mit zunehmend steilen Schaltflanken einhergehen kann, welche ein anregendes Kommutierungsschwingkreises gemäß Ausführungsbeispielen ermöglichen. $R_{max}$ kann beispielsweise zu einem Ohm, zu beispielsweise 0,5 Ohm oder beispielsweise zu 0,1 Ohm gesetzt werden und entspricht nicht notwendigerweise einem lokalen oder globalen Maximum der Überschwingungen.

Ein geeigneter Arbeitspunkt für die hierin beschriebenen Ausführungsbeispiele kann derart eingestellt werden, indem die Ansteuereinrichtung so ausgebildet wird, dass das Überschwingen an dem Halbleiterschalter dadurch gering gehalten wird, dass der Zeitpunkt des Schaltvorgangs so gewählt wird, dass der durch die Speicherdrossel, beispielsweise die Speicherdrossel 112, fließender Strom innerhalb eines Toleranzbereichs von 30%, bevorzugt 20%, mehr bevorzugt 15%, noch mehr bevorzugt 10% oder 5% oder möglichst exakt folgende Bedingung genügt:

$$I_{PH} = \frac{2U_{ZK}\sqrt{2\frac{C_{par}}{L_{par}}}}{\pi}$$

wobei Cpar den parasitären Kapazitätswert Cpar1 oder den Kapazitätswert $C_{par2}$ bezeichnen kann, die im Rahmen von Ausführungsbeispielen gleich gebildet sind. In anderen Worten entspricht $C_{par}$ genau einer Kapazität $C_T$ oder $C_D$ bzw. $C_{par1}$ oder $C_{par2}$, welche bspw. als identisch für diese Formel angenommen werden können. Für unterschiedlich große Kapazitäten können Oszillationen übrig bleiben, diese können jedoch innerhalb vordefinierter Grenzen gehalten werden. Für reale, nichtlineare und unterschiedlich große Kapazitäten kann der optimale ZOS-Punkt numerisch, durch Simulation und/oder durch Experiment bestimmt werden.

In anderen Worten können die Schaltung und die Betriebsart so angepasst sein, dass ein nahezu unbegrenzt schnelles Schalten oder ein unbegrenzt schnelles Schalten der Schalter ermöglicht wird. Dadurch können sich die Schaltverluste auf ein physikalisches Minimum reduzieren. Die Effizienz steigt, Verluste sinken, Chipfläche sinkt und/oder Kosten werden gespart. Die Schaltung und/oder die angepasste Betriebsart ermöglichen ein nahezu oder vollständig überspannungsfreies Abschalten. Dadurch lassen sich die Schalter bis an ihre Sperrspannungsfestigkeit betreiben. Es muss keine so große Spannungsreserve mehr eingehalten werden. Bei gleicher Spannungsklasse lassen sich Schaltungen somit mit höherer Spannung und somit höherer Leistung betreiben. Die Schaltung und die Betriebsart reduzieren oder verhindern die parasitären Oszillationen auf dem Zwischenkreis und reduzieren somit deutlich den nötigen Filteraufwand, um EMV-Richtlinien zu erfüllen. Ausführungsbeispiele sind hierbei nicht auf einen niederinduktiven Zwischenkreis angewiesen, da eine Anpassung der Resonanzfrequenz an beliebige Kapazitätswerte oder Induktivitätswerte ermöglicht ist. Die Anschlüsse und Gestaltung einer Leiter kann nach Kostenkriterien, Isolationskriterien, mechanischen Gesichtspunkten oder anderen Auslegungskriterien optimiert werden. Große mechanische Strukturen wie weit auseinanderliegende Anschraubpunkte mit sicherer Isolation und hoher mechanischer Belastbarkeit sind damit ohne Probleme realisierbar. Die Leiter können aus einfachen beliebigen Querstücken bestehen und sind nicht darauf angewiesen, durch ggf. aufwendige niederinduktive Bus Bars (Busleitungen) realisiert zu sein.

Fig. 5a zeigt ein schematisches Blockschaltbild eines Abwärtswandlers (Buck Converter) $510_1$, der alternativ oder zusätzlich zu dem Gleichspannungswandler 110 und/oder 210 in Vorrichtungen gemäß Ausführungsbeispielen verwendet werden kann.

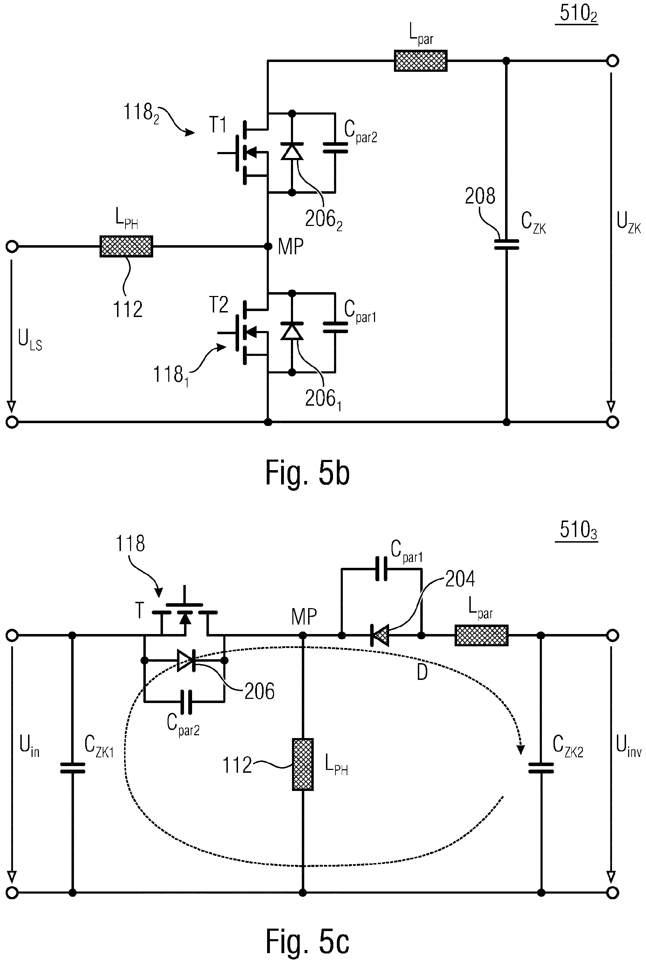

Fig. 5b zeigt ein schematisches Blockschaltbild eines Halbbrückenwandlers $510_2$, der alternativ oder zusätzlich zu den Gleichspannungswandlern 110, 210 und/oder $510_1$ in Vorrichtungen gemäß Ausführungsbeispielen angeordnet werden kann.

Fig. 5c zeigt ein schematisches Blockschaltbild eines invertierenden Wandlers 5103, der alternativ oder zusätzlich zu den Gleichspannungswandlern 110, 210, 5101 und/oder 5102 in Vorrichtungen gemäß Ausführungsbeispielen angeordnet werden kann.

Gemäß weiteren Ausführungsbeispielen ist vorgesehen, andere Wandler, beispielsweise einen Vollbrückenwandler und/oder einen Sperrwandler (Flyback) anzuordnen. Für Ausführungsbeispiele eignet sich sogar ein Flyback-Wandler hervorragend für die hierin beschriebenen Ausführungsbeispiele. Die Anforderungen oder Herausforderungen können als identisch betrachtet werden. Der klassische Flyback weist hohe Überspannungen aufgrund der Streuinduktivität auf. Die Streuinduktivität lässt sich für die hierin beschriebenen Ausführungsbeispiele (ZOS) nutzen.

Die hierin beschriebenen Ausführungsbeispiele ermöglichen eine Leistungsregelung trotz eines möglicherweise klein erscheinenden Arbeitspunktfensters im ZOS-Modus. So können beispielsweise ein Ab- und Zuschalten einzelner paralleler Stränge (sogenannte Phasen) ausgeführt werden. So kann beispielsweise bei einem 6-phasigen Wandler eine Leistungsvariation von 100% bis 16,6% möglich sein. Innerhalb der beschriebenen Arbeitspunkte kann eine Variation erfolgen, so dass vom idealen Arbeitspunkt abgewichen werden kann. Obwohl dies zu einer Zunahme der Überspannungen oder Oszillationen führen kann, kann dies unverändert innerhalb eines erlaubten Rahmens liegen, beispielsweise innerhalb von ± 30%, ± 10% oder weniger.

Alternativ oder zusätzlich kann ein sogenanntes Valley-Skipping (Talhüpfen) vorgenommen werden, indem der Wandler die Leistung variiert, indem der Einschaltzeitpunkt verschoben wird und dadurch Zeiträume ohne effektive Leistungsübertragung entstehen.

Dies ermöglicht eine Leistungsregelung um einen Faktor von beispielsweise ca. 2. Alternativ oder zusätzlich kann ein sogenannter Burst-Mode angesteuert werden, der speziell für den sehr niedrigen Lastbereich vorteilhaft sein kann, indem es die Möglichkeit gibt, nur sporadisch überhaupt Last zu übertragen. Dadurch ist in jedem Wandler ein Betrieb hinab bis zu 0% der Last möglich.

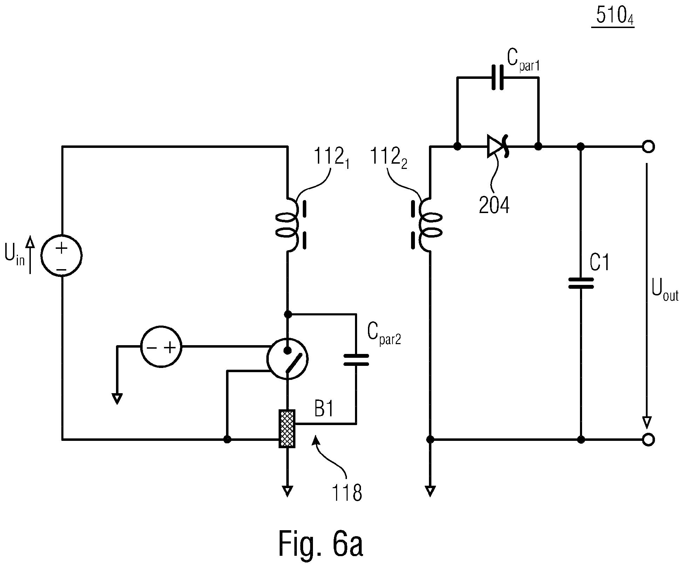

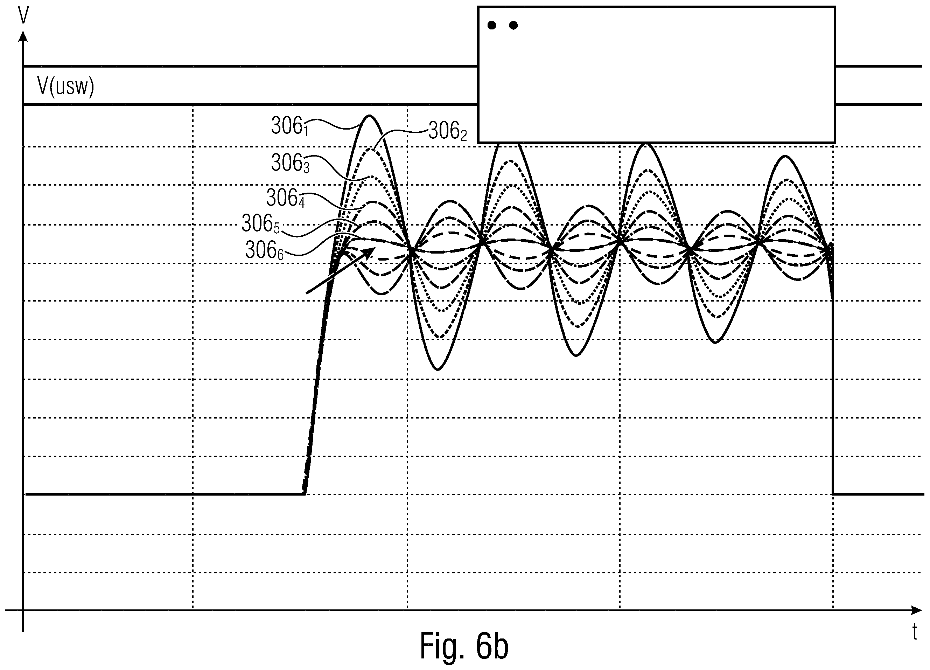

Die Fig. 6a zeigt ein schematisches Blockschaltbild eines Flyback-Wandlers 5104, der gemäß Ausführungsbeispielen alternativ oder zusätzlich zu den anderen hierin beschriebenen Gleichspannungswandlern in Vorrichtungen einsetzbar ist. Hierbei umfasst die Stromquelle eine Transformatorschaltung mit einer ersten Seite $112_1$ und einer zweiten Seite $112_2$, die jeweils als Drossel ausgeführt sein können. Fig. 6b zeigt ein schematisches Diagramm mit in dem Flyback-Wandler der Fig. 6a angeregten Oszillationen .

Fig. 6b zeigt einen schematischen Graphen mit einer Spannung an dem Halbleiterschalter 118 des Wandlers 5104 aus Fig. 6a an der Ordinate über die Zeitachse t. Kurven 3061 bis 3066 zeigen in zunehmender Indexreihenfolge eine zunehmende Anpassung des Flyback-Wandlers 5104 an dem beschriebenen ZOS-Betrieb. Das bedeutet, dass die Parasitäten Cpar1 und Cpar2 aneinander angepasst werden können, dass der Schaltpunkt in Abhängigkeit des Stroms durch die Drossel 1121 gewählt wird und dass das Schalten in einer entsprechenden Geschwindigkeit ausgeführt wird. Die Kurve 3061 zeigt dabei eine unangepasste Ausgangskapazität eines Flyback-Wandlers, der gemäß dem Stand der Technik unangepasst ist und beispielsweise in Abwesenheit eines Snubbers gebildet ist. In Kurve 3066 sind die Überschwingungen vergleichsweise gering.

Die Kurven zeigen eine Variation der sekundärseitigen Kapazität für den Fall, dass die natürliche Ausgangskapazität des Schalters und die natürliche Streuinduktivität parasitär genutzt werden. Alternativ oder zusätzlich ist auch eine Anpassung/Vergrößerung der Schaltkapazität Cpar2 oder Streuinduktivität Lpar implementierbar.

Eine Realisierung einer Serien-Induktivitäten der hierin beschriebenen Ausführungsbeispiele kann durch ein entsprechendes Einstellen der magnetischen Kopplung zwischen Primär- und Sekundärseite im Transformator erhalten werden. Dies kann sich direkt auf die Kommutierungskreisinduktivität auswirken. Diese Serien-Induktivität kann zusätzlich zu der parasitären Induktivität wirken. Ausführungsbeispiele ermöglichen die Nutzung einfacher Kondensatoren und ein Weglassen von aufwendigen Snubber-Kondensatoren, Block-Kondensatoren oder Puls-Kondensatoren. Alternativ oder zusätzlich ermöglichen Ausführungsbeispiele die Nutzung von allgemein gedrahteten Bauteilen anstelle von niederinduktiven Varianten, beispielsweise TO-Gehäusen (Transistor Outline). Kapazitäten können realisiert werden durch den Einbau hochkapazitiver Schalter, beispielsweise Trench (Graben)-Schalter und/oder die Nutzung großer Flächen durch den Einbau von hochbelastbaren Silizium-Kondensatoren und/oder durch den Einbau von Keramik-Kondensatoren.

Die hierin beschriebenen Ausführungsbeispiele ermöglichen neuartige Schaltungstopologien. Die Kommutierungskreisinduktivität kann als wirksames Bauteil der Schaltung genutzt werden, wobei dies die Verwendung zuzüglicher diskreter Induktivitäten und/oder entsprechender Anschlüsse nicht ausschließt. Ferner können Ausgangskapazitäten als aktives Bauteil der Schaltung in Verbindung mit der Serieninduktivität genutzt werden. Die Ausführungsbeispiele ermöglichen eine Reduktion von Überspannungen durch die Reduzierung des Gate-Widerstands auf parasitäre Größen, bspw. durch den Gatetreiber und/oder den internen Gatewiderstand des Transistors. Dies kann als Reduktion des Gatewiderstands auf Werte, welche den Schaltvorgang des Transistors nicht nennenswert beeinflussen/abbremsen bezeichnet werden, z. B. zusätzlich zu dem Ausgangswiderstand der Ansteuereinrichtung im Bereich von unter 1 Ohm für einen 25 mm2 großen SiC Chip. Das bedeutet, dass eine Kombination eines Treiberwiderstandswertes, eines Leitungswiderstandswertes und eines optionalen zusätzlichen und ggf. diskreten Widerstandswertes (R(Treiber)+R(Leitung)+R(evtl. Widerstand)) kleiner ist als 1 Ohm. Dies umfasst auch die Abwesenheit diskreter Widerstandselemente. Dies ermöglicht ferner die Auslegung der passiven und aktiven Bauteile innerhalb einer zusätzlichen Spannungsreserve von beispielsweise ± 30% oder ± 10%. Dies kann erreicht werden durch die Wahl der Abschaltströme so, dass diese im Bereich des ZOS-Betriebs liegen, beispielsweise innerhalb der genannten Toleranzbereiche. Dies kann auch auf mehrere Phasen angewendet werden, indem der Strom oder der mittlere Strom pro Phase unter Anwendung des ZOS-Betriebs eingestellt wird.

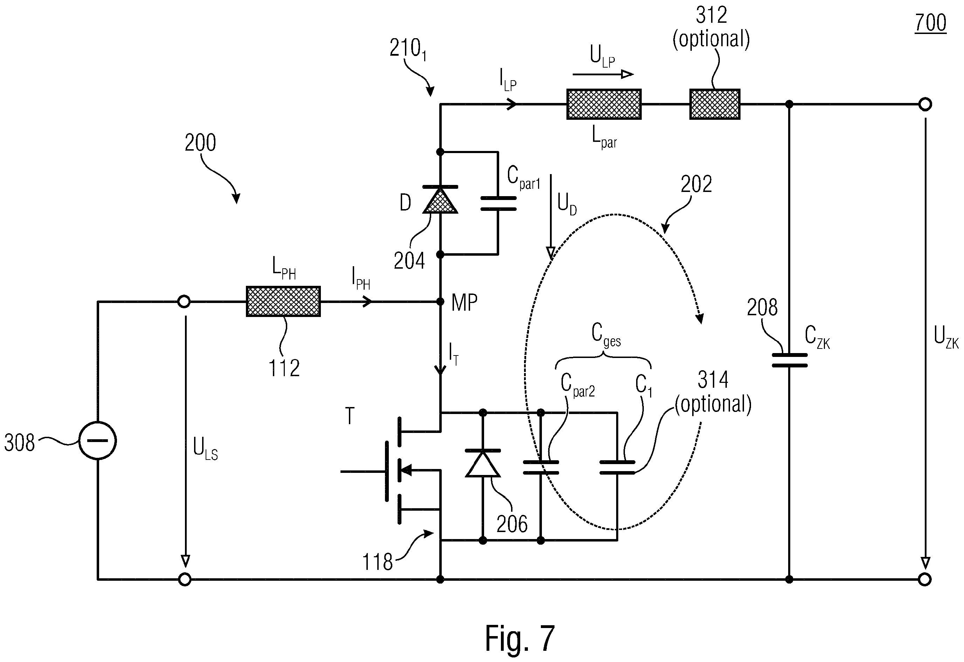

Fig. 7 zeigt ein schematisches Blockschaltbild einer elektrischen Schaltung 700 gemäß einem Ausführungsbeispiel. Die elektrische Schaltung 700 umfasst beispielsweise die Vorrichtung 200 mit einem modifizierten Gleichspannungswandler 2101 gemäß einem Ausführungsbeispiel. Alternativ oder zusätzlich können andere hierin beschriebene Gleichspannungswandler eingesetzt werden. Die elektrische Schaltung umfasst eine Spannungsquelle 308, die mit dem Halbleiterschalter 118 elektrisch gekoppelt ist, beispielsweise um eine zu wandelnde Spannung ULS zu wandeln. Die Spannungsquelle 308 ist ausgebildet, um während eines Betriebs der Vorrichtung bzw. elektrischen Schaltung 700 die Spannung ULS an dem Gleichspannungswandler $210_1$ anzulegen, die zumindest 84% einer Sperrspannung des Halbleiterschalters 118 entspricht. Gemäß weiteren Ausführungsbeispielen kann eine Spannung von zumindest 90% oder zumindest 95% angelegt werden. Es ist auch möglich, Spannungen anzulegen, die im Wesentlichen oder nahezu 100% der Sperrschaltung des Halbleiterschalters 118 entsprechen, da eine Kompensation der Überschwingungen durch die Ausführungsbeispiele ermöglicht wird. In der Konfiguration gemäß Fig. 7, wo ein Aufwärtswandler als Gleichspannungswandler $210_1$ eingesetzt wird, kann die Spannungsquelle 308 eingangsseitig angeordnet sein. Alternativ, beispielsweise bei Verwendung eines Abwärtswandlers, kann der Gleichspannungswandler ausgebildet sein, um basierend auf der von der elektrischen Spannungsquelle 308 bereitgestellten Eingangsspannung eine elektrische Ausgangsspannung bereitzustellen, die zumindest 84%, zumindest 90% oder zumindest 95%, aber auch 100% oder nahe 100% der Sperrspannung des Halbleiterschalters entspricht.

Der Gleichspannungswandler $210_1$ kann gegenüber dem Gleichspannungswandler 210 aus Fig. 2a dahin gehend modifiziert sein, dass er eine optionale diskrete Induktivität 312 umfassen kann, beispielsweise gebildet durch Leitungen oder Spulen wie Luftspulen oder Spulen mit Magnetkern. In bekannten Konzepten wird stets versucht, die Induktivität des Kommutierungskreises gering zu halten. Gemäß Ausführungsbeispielen wird jedoch eine Anpassung der Induktivität durch Hinzufügen von parasitären und/oder diskreten Induktivitäten genutzt, um eine Übereinstimmung mit der im Zusammenhang mit der Fig. 2a erläuterten Beziehung zu erhalten. Das beutet, die Induktivität des Kommutierungskreises wird künstlich erhöht.

Alternativ oder zusätzlich kann der Gleichspannungswandler $210_1$ optional eine diskrete Kapazität, beispielsweise einen Kondensator, aufweisen, der möglicherweise parallel zu der parasitären Kapazität $C_{par2}$ und/oder $C_{par1}$ angeordnet sein kann, um die jeweilige Kapazität anzupassen. Die zusätzlichen diskreten Bauteile 312 und/oder 314 können so angeordnet sein, dass sie in dem Kommutierungskreis 202 wirken, das bedeutet, Teil des Area-Schwingkreises. Eine derartige Modifikation kann auch in Abwesenheit der Spannungsquelle ausgeführt sein, so dass die Erläuterungen im Hinblick auf die optionalen zusätzlichen Elemente auch für die hierin beschriebenen Vorrichtungen gelten. Insbesondere kann in hierin beschriebenen Vorrichtungen bspw. durch die Hinzufügung von elektrischen Kapazitäten eine Symmetrie bezüglich der wirksamen Kapazität über dem Freilaufelement 204 und dem Halbleiterschaler 118 erhalten werden. Auch kann basierend auf hinzugefügten elektrischen Impedanzen eine Anpassung an die im Zusammenhang mit der Fig. 2a erläuterten Formel des Phasenstroms erhalten werden.

Entgegen der vorherrschenden Meinung, dass eine Reduzierung von Überspannungen im Gleichspannungswandler durch geringe Induktivitäten und langsame Schaltzeiten ermöglicht wird, ermöglichen die hierin beschriebenen Ausführungsbeispiele Lösungen, die auf einer gegensätzlichen Lehre beruhen. Überraschenderweise kann mit zunehmendem Strom und zunehmender Schaltungsgeschwindigkeit eine abnehmende Überspannung erhalten werden. Dadurch können langwierige Probleme zum Stand der Technik gelöst werden und ein andauernder Kompromiss zwischen Schaltverlusten und Schaltgeschwindigkeiten/Abschaltüberspannungen aufgelöst werden. Gemäß dem Stand der Technik werden Halbleiterschalter mit Gatevorwiderständen ausgebremst, wie es in den jeweiligen Datenblättern zu finden ist. Schraubanschlüsse an Halbleiterschaltern dominieren gegenüber niederinduktiven Modulen. Die hierin beschriebenen Ausführungsbeispiele ermöglichen einen hocheffizienten Betrieb, da kaum Oszillationen auftreten. Dies ist günstig für EMV-Anforderungen, günstig für die Reduzierung von Verlusten und somit auch die Reduzierung von Kosten.

Der Strom Lpar schwingt im Idealfall nicht über. Im Idealfall ergibt sich ferner keine bleibende Schwingung, das bedeutet, eine Schwingung wird höchstens unvollständig ausgeführt. Real ist dies besonders aufgrund eines nichtidealen Steps, das bedeutet, einer lediglich endlich steilen Flanke nicht zu 100% ermöglicht. Die Betrachtung kann jedoch näherungsweise herangezogen werden.

Gemäß einer Ausführungsform werden mehrere Aspekte hierin beschriebener Ausführungsbeispiele kombiniert. So kann eine elektrische Schaltung gemäß Ausführungsbeispielen eine Vorrichtung aufweisen, bspw. eine hierin beschriebene Vorrichtung. Diese kann Folgendes umfassen: Einen Gleichspannungswandler mit einem Halbleiterschalter und mit einer Speicherdrossel (112), wobei der Gleichspannungswandler einen Kommutierungsschwingkreis aufweist, der zumindest teilweise von parasitären Eigenschaften (Lpar, Cpar) des Gleichspannungswandlers bestimmt ist. Ferner kann die Vorrichtung eine Ansteuereinrichtung (150) aufweisen, die konfiguriert ist, um den Halbleiterschalter (118) durch Ausführen eines Schaltvorganges zu schalten. Die Ansteuereinrichtung (150) ist konfiguriert, um den Schaltvorgang mit einer Schaltdauer (∆t) auszuführen, die kleiner ist, als eine Periodendauer einer Resonanzfrequenz des Kommutierungsschwingkreises. Die Ansteuereinrichtung (150) ist ausgebildet, um einen Zeitpunkt des Schaltvorganges (t0) so zu wählen, dass ein durch die Speicherdrossel (112) fließender Strom (IPH) ein Überschwingen (Umax-Unom) an dem Halbleiterschalter (118) von höchstens 30% bezogen auf einen Ruhezustand (Unom) des Halbleiterschalters (118) erzeugt. Gleichzeitig kann der Kommutierungsschwingkreis ein diskretes induktives oder kapazitives Bauelement aufweisen, das so verschaltet ist, um kombinatorisch mit einem parasitären Kapazität (Cpar; Cpar1; Cpar2) oder einem parasitären Induktivitätswert (Lpar) des Kommutierungsschwingkreises wirkt und dessen Resonanzfrequenz beeinflusst als seriell oder parallel, etwa das Element 312 und/oder 314. Die Ansteuereinrichtung (150) kann ausgebildet sein, um um das Überschwingen an dem Halbleiterschalter (118) von höchstens 30 % bezogen auf einen Ruhezustand (Unom) des Halbleiterschalters (118) zu erzeugen, den Zeitpunkt (t0) des Schaltvorganges so zu wählen, dass der durch die Speicherdrossel (112) fließende Strom (IPH) innerhalb eines Toleranzbereichs von 30 % folgender Bedingung genügt:

$$I_{PH} = \frac{2U_{ZK}\sqrt{2\dfrac{C_{par}}{L_{par}}}}{\pi}$$

wobei $I_{PH}$ den Strom durch die Speicherdrossel zum Schaltzeitpunkt, $U_{ZK}$ eine elektrische Spannung des Gleichspannungswandlers bzw. die Kommutierungsspannung, $C_{par}$ einen linearisierten parasitären elektrischen Kapazitätswert des Gleichspannungswandlers und $L_{par}$ einen parasitärer Induktivitätswert des Gleichspannungswandlers umfasst.

Gemäß einer weiteren Ausführungsform kann die elektrische Schaltung die parasitäre Induktivität ($L_{par}$) durch eine entsprechende Ausgestaltung der elektrischen Leiter der Vorrichtung erreichen. Das bedeutet, die parasitäre Induktivität wird durch die Ausgestaltung der Leiter, zum Anschließen der elektrischen Schaltung, etwa bezüglich der Länge, der Breite, der Höhe und/oder des Querschnitts und dergleichen so angepasst, dass der gewünschte Induktivitätswert erhalten wird.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Vorrichtung (100) mit:

   einem Gleichspannungswandler (110; 210; $210_1$; $510_1$, $510_2$, $510_3$; $510_4$) mit einem Halbleiterschalter und mit einer Stromquelle (112), wobei der Gleichspannungswandler einen Kommutierungsschwingkreis aufweist, der zumindest teilweise von parasitären Eigenschaften ($L_{par}$, $C_{par}$) des Gleichspannungswandlers bestimmt ist;
   einer Ansteuereinrichtung (150), die konfiguriert ist, um den Halbleiterschalter (118) durch Ausführen eines Schaltvorganges zu schalten;
   wobei Ansteuereinrichtung (150) konfiguriert ist, um den Schaltvorgang mit einer Schaltdauer ($\Delta t$) auszuführen, die kleiner ist, als eine Periodendauer einer Resonanzfrequenz des Kommutierungsschwingkreises; und
   wobei die Ansteuereinrichtung (150) ausgebildet ist, um einen Zeitpunkt des Schaltvorganges ($t_0$)so zu wählen, dass ein durch die Stromquelle (112) bereitgestellter Strom ($I_{PH}$) ein Überschwingen ($U_{max}$-$U_{nom}$) an dem Halbleiterschalter (118) von höchstens 30 % bezogen auf einen Ruhezustand ($U_{nom}$) des Halbleiterschalters (118) erzeugt.

2. Vorrichtung (100) gemäß Anspruch 1, bei der der Gleichspannungswandler ein Freilaufelement (204) aufweist, die mit dem Halbleiterschalter (118) Teil eines Kommutierungskreises (202) ist, wobei ein parallel zu dem Freilaufelement (204) wirkender erster elektrischer Kapazitätswert ($C_{par1}$) und ein parallel zu dem Halbleiterschalter wirkender zweiter elektrischer Kapazitätswert ($C_{par2}$; $C_{ges}$) innerhalb eines Toleranzbereichs von 30 % gleich sind, wobei der erste Kapazitätswert ($C_{par1}$) und der zweite Kapazitätswert ($C_{par2}$; $C_{ges}$) in dem Kommutierungsschwingkreiswirken.

3. Vorrichtung (100) gemäß Anspruch 2, bei der der erste elektrische Kapazitätswert oder der zweite elektrische Kapazitätswert ($C_{ges}$) durch eine Kombination eines parasitären elektrischen Kapazitätswertes ($C_{par2}$)und eines kapazitiven Bauelements (314) gebildet werden.

4. Vorrichtung (100) gemäß einem der vorangehenden Ansprüche, bei der der Kommutierungsschwingkreis zumindest einen parallel zu dem Halbleiterschalter (118) wirkenden elektrische Kapazitätswert ($C_{par2}$; $C_{ges}$) und einen in Serie geschalteten elektrischen Induktivitätswert ($L_{par}$, 312) umfasst.

5.  Vorrichtung (100) gemäß einem der vorangehenden Ansprüche, bei der der die Ansteuereinrichtung (150) ausgebildet ist, um, um das Überschwingen an dem Halbleiterschalter (118) von höchstens 30 % bezogen auf einen Ruhezustand ($U_{nom}$) des Halbleiterschalters (118) zu erzeugen, den Zeitpunkt ($t_0$) des Schaltvorganges so zu wählen, dass der durch die Stromquelle (112) bereitgestellter Strom ($I_{PH}$) innerhalb eines Toleranzbereichs von 30 % folgender Bedingung genügt:

$$I_{PH} = \frac{2U_{ZK}\sqrt{2\frac{C_{par}}{L_{par}}}}{\pi}$$

wobei $I_{PH}$ den Strom der Stromquelle zum Schaltzeitpunkt, $U_{ZK}$ eine elektrische Spannung des Gleichspannungswandlers, $C_{par}$ einen linearisierten parasitären elektrischen Kapazitätswert des Gleichspannungswandlers und $L_{par}$ einen parasitärer Induktivitätswert des Gleichspannungswandlers umfasst.

6.  Vorrichtung gemäß einem der vorangehenden Ansprüche, bei der der Kommutierungsschwingkreis ein diskretes induktives oder kapazitives Bauelement aufweist, das so verschaltet ist, um kombinatorisch mit einem parasitären Kapazität ($C_{par}$; $C_{par1}$; $C_{par2}$) oder einem parasitären Induktivitätswert ($L_{par}$) des Kommutierungsschwingkreises wirkt und dessen Resonanzfrequenz beeinflusst.

7.  Vorrichtung (100) gemäß einem der vorangehenden Ansprüche, bei der die Ansteuereinrichtung (150) ausgebildet ist, um den Schaltvorgang mit einer Schaltschaltdauer ($\Delta t$) auszuführen, die kleiner ist, als die Hälfte einer Periodendauer (303) der Resonanzfrequenz des Kommutierungsschwingkreises.

8.  Vorrichtung (100) gemäß einem der vorangehenden Ansprüche, bei der die Ansteuereinrichtung (150) ausgebildet ist, um den Schaltvorgang mit einer Schaltschaltdauer ($\Delta t$) auszuführen, die kleiner ist, als 8 ns.

9.  Vorrichtung (100) gemäß einem der vorangehenden Ansprüche, bei der der Halbleiterschalter einen Steueranschluss (122) aufweist, der mit der Ansteuereinrichtung (150) verbunden ist, wobei ein Widerstandswert ($R_{gate}$; 224) zwischen der Ansteuereinrichtung (150) und dem Steueranschluss (122) zusätzlich zu einem Ausgangswiderstand er Ansteuereinrichtung einen Wert von höchstens 1 $\Omega$ aufweist.

10. Vorrichtung (100) gemäß Anspruch 9, die in Abwesenheit eines Gatevorwiderstandelementes gebildet ist.

11. Vorrichtung (100) gemäß einem der vorangehenden Ansprüche, bei der Erregerschwingkreis durch den Schaltvorgang angeregt wird, wobei der Gleichspannungswandler einen Kommutierungskreis (202) aufweist, der ein Freilaufelement (204) umfasst, wobei das Freilaufelement (204) wirksam ist, um eine Schwingung des Erregerschwingkreises vor Ablauf einer vollständigen Schwingungsperiode (303) zu beenden, so dass der Erregerschwingkreis höchstens eine unvollständige Schwingung ausführt.

12. Vorrichtung (100) gemäß einem der vorangehenden Ansprüche, bei der der Halbleiterschalter (118) ausgelegt ist, um in einem bestimmungsgemäßen Betrieb hart schaltend betrieben zu werden; und/oder bei der die Ansteuereinrichtung (150) ausgebildet ist, um den Halbleiterschalter (118) hart zu schalten.

13. Vorrichtung (100) gemäß einem der vorangehenden Ansprüche, bei der der Kommutierungsschwingkreis Teil einer Kommutierungszelle des Gleichspannungswandlers ist.

14. Vorrichtung (100) gemäß einem der vorangehenden Ansprüche, bei der der Gleichspannungswandler eines aus einem Aufwärtswandler (210; $210_1$), einem Abwärtswandler ($510_1$), einem Halbbrückenwandler ($510_2$), einem Vollbrückenwandler, einem invertierendem Wandler ($510_3$) und einem Sperrwandler ($510_4$) umfasst.

15. Elektrische Schaltung (700) mit einer Vorrichtung (100) gemäß einem der vorangehenden Ansprüche und einer elektrischen Spannungsquelle (308), die mit dem Halbleiterschalter (118) elektrisch gekoppelt ist; wobei die elektrische Spannungsquelle (308) ausgebildet ist, um während eines Betriebs der Vorrichtung eine elektrische Spannung ($U_{LS}$) an den Gleichspannungswandler anzulegen, die zeitweise zumindest 84 % einer Sperrspannung des Halbleiterschalters (118) entspricht; oder wobei der Gleichspannungswandler ausgebildet ist, um basierend auf einer von der elektrischen Spannungsquelle bereitgestellten elektrischen Eingangsspannung eine elektrische Ausgangsspannung ($U_{HS}$; $U_{LS}$) bereitzustellen, die zeitweise zumindest 84 % einer Sperrspannung des Halbleiterschalters entspricht.

16. Elektrische Schaltung gemäß Anspruch 15, bei der

die parasitäre Induktivität ($L_{par}$) durch eine entsprechende Ausgestaltung elektrischer Leiter der Vorrichtung erreicht ist.

17. Vorrichtung mit:

einem Gleichspannungswandler, mit einer ersten Seite (114) und einer zweiten Seite (116), zwischen denen eine Kommutierungszelle umfassend einem Halbleiterschalter (118) und einem Freilaufelement (204) angeordnet ist; wobei der Kommutierungskreis mit einer Stromquelle (112) verbunden ist, die konfiguriert ist, um einen Phasenstrom ($I_{PH}$) für den Gleichspannungswandler bereitzustellen; wobei während eines Ruhezustandes des Halbleiterschalters (118) in der Kommutierungszelle eine Kommutierungsspannung ($U_{ZK}$) anliegt; wobei der Kommutierungskreis einen Kommutierungsschwingkreis (202) umfassend einen elektrischen Induktivitätswert ($L_{par}$; 312) und einen elektrischen Kapazitätswert ($C_{par1}$, $C_{par2}$; $C_1$; $C_{ges}$) aufweist, wobei der Kommutierungsschwingkreis (202) so gebildet ist, innerhalb eines Toleranzbereichs von 30 % gilt, dass

$$I_{PH} = \frac{2U_{ZK}\sqrt{2\dfrac{C}{L}}}{\pi}$$

wobei $I_{pH}$ den Phasenstrom zum Schaltzeitpunkt, $U_{ZK}$ die Kommutierungsspannung, C der elektrische Kapazitätswert und L den elektrischen Induktivitätswert beschreibt.

18. Vorrichtung gemäß Anspruch 17, bei der eine elektrische Kapazität und/oder eine elektrische Induktivität des Kommutierungsschwingkreises durch zusätzliche diskrete Bauelemente (312, 314) angepasst ist.

Fig. 1

Fig. 2a

Fig. 2b

Fig. 3a

Fig. 3b

Fig. 3c

Fig. 4a

$U_{max}$

$R_{max}$        $R_1$        $R_{gate}$

## Fig. 4b

$510_1$

## Fig. 5a

$510_2$

Fig. 5b

$510_3$

Fig. 5c

Fig. 6a

Fig. 6b

Fig. 7

EP 3 512 085 A1

Fig. 8a

Fig. 8b

EP 3 512 085 A1

**Europäisches Patentamt**
**European Patent Office**
**Office européen des brevets**

# EUROPÄISCHER RECHERCHENBERICHT

**Nummer der Anmeldung**

EP 18 15 1431

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GUO SUXUAN ET AL: "3.38 Mhz operation of 1.2kV SiC MOSFET with integrated ultra-fast gate drive", 2015 IEEE 3RD WORKSHOP ON WIDE BANDGAP POWER DEVICES AND APPLICATIONS (WIPDA), IEEE, 2. November 2015 (2015-11-02), Seiten 390-395, XP032839600, DOI: 10.1109/WIPDA.2015.7369298 [gefunden am 2015-12-30] * Zusammenfassung; Abbildungen 1,2,8,9 * * Seite 391 * * Seite 393, rechte Spalte * * Section IV * | 1-18 | INV. H02M3/156 H02M3/335 H02M1/44 ADD. H02M1/00 |
| A | BURGOS R ET AL: "Design considerations of a fast 0-Î CR gate-drive circuit for 1.2 kV SiC JFET devices in phase-leg configuration", ENERGY CONVERSION CONGRESS AND EXPOSITION, 2009. ECCE. IEEE, IEEE, PISCATAWAY, NJ, USA, 20. September 2009 (2009-09-20), Seiten 2293-2300, XP031887554, DOI: 10.1109/ECCE.2009.5316075 ISBN: 978-1-4244-2893-9 * Section I, II, IV * | 1-18 | |
| | ----- | | |
| | -/-- | | |

| | |
|---|---|
| | **RECHERCHIERTE SACHGEBIETE (IPC)** |
| | H02M |

Der vorliegende Recherchenbericht wurde für alle Patentansprüche erstellt

| Recherchenort | Abschlußdatum der Recherche | Prüfer |
|---|---|---|
| Den Haag | 10. Juli 2018 | Kail, Maximilian |

Seite 1 von 2

Europäisches
Patentamt

European
Patent Office

Office européen
des brevets

# EUROPÄISCHER RECHERCHENBERICHT

**Nummer der Anmeldung**

EP 18 15 1431

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | ZHANG LIQI ET AL: "Integrated SiC MOSFET module with ultra low parasitic inductance for noise free ultra high speed switching", 2015 IEEE 3RD WORKSHOP ON WIDE BANDGAP POWER DEVICES AND APPLICATIONS (WIPDA), IEEE, 2. November 2015 (2015-11-02), Seiten 224-229, XP032839598, DOI: 10.1109/WIPDA.2015.7369296 [gefunden am 2015-12-30] * Zusammenfassung; Abbildungen 1,3,4,5,6 * ----- | 1-18 | |
| A | MATLOK S ET AL: "Switching SiC devices faster and more efficient using a DBC mounted terminal decoupling Si-RC element", MATERIALS SCIENCE FORUM, TRANS TECH PUBLICATIONS LTD, 25. September 2016 (2016-09-25), Seite 1, XP033093450, ISSN: 1662-9752, DOI: 10.4028/WWW.SCIENTIFIC.NET/MSF.897.689 [gefunden am 2017-05-06] * Abbildungen 2,3 * ----- | 1-18 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 10. Juli 2018 | Kail, Maximilian |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes
  Dokument

EPO FORM 1503 03.82 (P04C03)

Seite 2 von 2